(19) Europäisches Patentamt
European Patent Office
Office européen des brevets

(11) EP 2 759 052 B1

## (12) EUROPÄISCHE PATENTSCHRIFT

(45) Veröffentlichungstag und Bekanntmachung des Hinweises auf die Patenterteilung:
**24.02.2021 Patentblatt 2021/08**

(21) Anmeldenummer: **12778604.4**

(22) Anmeldetag: **18.09.2012**

(51) Int Cl.:
**H02N 2/10** (2006.01)    **G02B 26/08** (2006.01)

(86) Internationale Anmeldenummer:
**PCT/EP2012/003895**

(87) Internationale Veröffentlichungsnummer:
**WO 2013/041212 (28.03.2013 Gazette 2013/13)**

### (54) DREHSTELLER

ROTARY ACTUATOR

ACTIONNEUR ROTATIF

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **19.09.2011 DE 102011113760**

(43) Veröffentlichungstag der Anmeldung:
**30.07.2014 Patentblatt 2014/31**

(73) Patentinhaber:
• **Kappel, Andreas**
  **85649 Brunnthal (DE)**
• **Fraunhofer Gesellschaft zur Förderung der angewandten Forschung e.V.**
  **80686 München (DE)**

(72) Erfinder: **GOEPEL, Ernst**
**82131 Gauting (DE)**

(74) Vertreter: **Rösler, Uwe et al**
**Rösler Patentanwaltskanzlei**
**Landsberger Strasse 480a**
**81241 München (DE)**

(56) Entgegenhaltungen:
**DE-C1- 4 033 089    US-A- 3 035 126**
**US-A- 5 626 312**

EP 2 759 052 B1

**Beschreibung**

Die vorliegende Erfindung betrifft einen Elektroantrieb, im Folgenden als Drehsteller bezeichnet, insbesondere einen einfach steuer- und regelbaren Drehsteller, der sich durch eine hohe Genauigkeit, eine hohe Dynamik und einen kompakten Aufbau auszeichnet.

In vielen technischen Bereichen besteht die Notwendigkeit zur elektrisch steuerbaren Bewegung oder Manipulation von Objekten. Die geforderte Bewegung der Objekte kann dabei eine Linearbewegung, eine Rotationsbewegung, eine aus der Überlagerung von Linear- und Rotationsbewegungen sich ergebende Bewegung, insbesondere eine Bewegung entlang einer beliebigen Trajektorie sein. Vielfach besteht die Erfordernis zur Durchführung von Drehbewegungen oder drehartigen Schwenkbewegungen von Objekten, wobei die Drehbewegung vielfach auf einen Winkelbereich begrenzt ist, jedoch möglichst dynamisch und genau erfolgen soll. Anwendungsbeispiele hierfür finden sich in den Bereichen Optik, Mechanik, Hydraulik, Pneumatik und Elektrik. Weit verbreitet sind optische Ablenkeinheiten, bei denen ein optisches Element, beispielsweise ein Spiegel, eine Linse oder eine Blende in den Strahlengang geschwenkt oder im Strahlengang gedreht wird. Technische Anwendung finden solche Ablenksysteme oder Ablenkeinheiten unter anderem beim Laserstrahlschneiden, bei Laserdruckern als Scannerspiegel oder bei optischen Projektionssystemen, beispielsweise bei Head-Up-Diplays (HUD) zur Verstellung der Projektionsspiegel und Linsen. Nachführ- und Zielverfolgungssysteme (Tracking) sind ein weiteres Anwendungsgebiet.

Auch in den Bereichen Hydraulik und Pneumatik werden zur Steuerung von Fluidströmen neben linear bewegten Ventilelementen häufig rotatorisch bewegte Ventilelemente eingesetzt, um beispielsweise eine Zu- oder Ablauföffnung elektrisch gesteuert öffnen und verschließen zu können. Zur Proportionalsteuerung eines Fluidvolumenstromes müssen die Ventilelemente die Fluidöffnung nicht nur vollständig öffnen und vollständig verschließen können, sondern in der Lage sein, jede Zwischenstellung einzunehmen.

Weit verbreitet sind Schwenk- und Drehvorrichtungen auch in den Bereichen Automatisierungstechnik, Produktionstechnik und Medizintechnik, wo sie zur Manipulation und/oder zum Transfer von Objekten, z.B. bei Bestückungsautomaten, oder als elektrisch betätigbare Schalter dienen. Im Kfz-Bereich und bei Zweirädern können derartige Aktoren zur Getriebeschaltung eingesetzt werden oder bei Fahrrädern und/ober E-Bikes zur elektrischen Betätigung der Umwerfer für eine Kettenschaltung.

Das technische Problem und die Herausforderung bei derartigen elektrischen Drehstellern besteht darin, trägheits- und massebehaftete Objekte einerseits mit hoher Dynamik und andererseits genau zu verstellen.

Zur optischen Strahlablenkung werden heute überwiegend Galvanometer oder Galvanometer Scanner eingesetzt, die aus einem massearmen Spiegel und einer elektrischen, überwiegend elektromagnetischen oder elektrostatischen Ablenkeinheit für den Spiegel bestehen. Mit trägheitsarmen Spiegeln kann eine hohe Dynamik und Genauigkeit erreicht werden. Eine dynamische und genaue Bewegung von Objekten größerer Masse ist mit derartigen Systemen nicht möglich. Damit ist der Einsatzbereich von Galvanometer Ablenksystemen stark begrenzt.

Zur Drehbetätigung von Objekten größerer Masse werden, dem Stand der Technik entsprechend, Elektromagnete oder Elektromotoren verwendet. Hierbei besteht jedoch ein Zielkonflikt zwischen möglichst hoher Dynamik und möglichst hoher Genauigkeit, d.h. es kann nur jeweils eine der Zielgrößen auf Kosten der anderen optimiert werden. Die am Markt befindlichen elektrischen Dreh- und Schwenkantriebe stellen diesbezüglich einen Kompromiss zwischen geforderter Genauigkeit und erreichbarer Dynamik dar.

Die Druckschrift US 5,626,312 A offenbart einen piezoelektrischen Aktor, der zum Verkippen der die Rotorblattebene eines Hubschraubers verändernden Taumelscheibe in der Lage sein soll. Der bekannte Aktor verfügt über einen axial starren, jedoch torsional flexibel ausgebildeten Hohlzylinderkörper, dessen zwei Hohlzylinderstirnseiten jeweils mit Endplatten fest verbunden sind, die den Hohlzylinder radial überragen. Der Hohlzylinder ist axialsteif und torsionsweich ausgebildet.

Ziel der vorliegenden Erfindung ist es, einen elektrisch steuerbaren Drehsteller bereitzustellen, der eine hochdynamische Drehwinkelverstellung massebehafteter Objekte bei sehr hoher Genauigkeit ermöglicht.

Diese Aufgabe wird gelöst durch den Drehsteller nach Anspruch 1. Vorteilhafte Weiterbildungen des erfindungsgemäßen Drehstellers werden durch die abhängigen Ansprüche gegeben.

Erfindungsgemäß wird ein Drehsteller bereitgestellt, der insbesondere die folgenden Merkmale aufweist:

- mindestens einen Drehwandler bestehend aus mindestens zwei Endbereichen, die miteinander bezüglich einer Längsachse nicht parallel orientierter Strukturen verbunden sind.
- mindestens einen Aktor, zur Ausübung von Linearkräften auf den mindestens einen Drehwandler in Richtung der Längsachse
- mindestens ein Element zur Befestigung von mindestens einem ersten Bereich des Drehwandlers an einem Inertialsystem
- mindestens ein Element zur Befestigung von mindestens einem zweiten Bereich des Drehwandlers an einem Objekt

so dass sich bei der Beaufschlagung des Drehwandlers mit Kräften in Richtung der Längsachse der mindestens eine erste Bereich und der mindestens eine zweite Bereich des Drehwandlers zueinander verdrehen.

Ein erfindungsgemäßer Drehwandler kann insbesondere

- aus einem Hohlköper bestehen, dessen Wandung Arme aufweist, die auf dem Umfang des Hohlkörpers bezüglich einer Längsachse des Hohlkörpers unter einem Winkel rotationssymmetrisch orientiert und mit Endbereichen verbunden sind. Ein solcher Drehwandler kann beispielsweise aus einem Hohlzylinder oder einem Hohlkegel durch Einbringung von Schlitzen in die Wandung des Hohlkörpers hergestellt werden.

- aus stabartigen Verbindungen beliebiger Form und beliebigen Querschnittes der Endbereiche bestehen, wobei die stabartigen Verbindungen unter einem Winkel in Bezug auf eine Längsachse geneigt und rotationssymmetrisch orientiert sind. Ein solcher gitterartiger Drehwandler kann beispielsweise aus zwei ring- oder scheibenförmigen Endbereichen durch Befestigung von Stäben, die gegenüber der Längsachse um einen Winkel geneigt sind, hergestellt werden.

- aus entlang einer Längsachse verdrillten Voll- oder Hohlprofilen bestehen, wobei beliebige Profilquerschnitte möglich sind. Insbesondere können die Profilquerschnitte entlang der Längsachse unterschiedliche Ausdehnungen besitzen, z.B. sich erweitern oder verjüngen oder es kann ein Profilquerschnitt in einen anderen übergehen, solange sich der Dreh/Windungssinn der Verdrillung nicht ändert. Die Endbereiche des Drehwandlers werden hierbei durch die Enden der verdrillten Stab- oder Hohlprofile gebildet.

- aus Kombinationen von zwei oder mehreren einzelnen Drehwandlern der oben beschriebenen Art bestehen. Beispielsweise kann ein erster Drehwandler mit einem linken Dreh/Windungssinn mit seinem einen Endbereich axial mit dem Endbereich eines zweiten Drehwandler mit einem rechten Dreh/Windungssinn mechanisch verbunden werden, so dass die Verbindungsstelle einen Äquator darstellt, der sich bei Beaufschlagung der Endbereiche dieses kombinierten Drehwandlers mit Kräften in Richtung der Längsachse gegenüber den Endbereichen verdreht.

In einer bevorzugten Ausführung weist der Drehsteller auf:

- mindestens eine, als Drehwandler dienende rohrförmige Struktur, deren Wand aus streifenförmigen Armen besteht, die auf dem Umfang der rohrförmigen Struktur bezüglich deren Längsachse unter einem Winkel orientiert sind
- ringförmige Bereiche der mindestens einen rohrförmigen Struktur, über die die Enden der streifenförmigen Arme miteinander verbunden sind, auch als Befestigungsbereiche bezeichnet,
- eine Formgebung der streifenförmigen Arme derart, dass diese bezüglich Bewegungen der ringförmigen Befestigungsbereiche in Richtung der Längsachse der rohrförmigen Struktur steif, bezüglich Drehungen um die Längsachs der rohrförmigen Struktur aber weich sind
- mindestens einen Halter für die mindestens eine rohrförmige Struktur, bevorzugt an einem der Befestigungsbereiche
- mindestens ein Befestigungselement für ein zu drehendes Objekt, an der mindestens einen rohrförmigen Struktur, bevorzugt an einem der Befestigungsbereiche
- mindestens einen elektrisch betätigbaren Aktor, der durch Anlegen elektrischer Signalspannungen der Amplitude und/oder der Polarität der elektrischen Signalspannungen proportionale Kräfte auf die Enden, insbesondere auf die Befestigungsbereiche der Arme, der mindestens einen rohrförmigen Struktur in deren Längsachse ausüben kann

so dass die von dem Aktor auf die Enden der rohrförmigen Struktur ausgeübten Kräfte zu proportionalen Längenänderungen der rohrförmigen Struktur führen, wodurch sich der Winkel der streifenförmigen Arme auf dem Umfang der rohrförmigen Struktur bezüglich deren Längsachse ändert und sich mindestens einer der ringförmigen Befestigungsbereiche der streifenförmigen Arme um die Längsachse der rohrförmigen Struktur als Rotationsachse gegenüber mindestens einem der anderen ringförmigen Befestigungsbereiche der streifenförmigen Arme verdreht.

Der erfindungsgemäße Drehsteller ermöglicht die Ausführung von Drehbewegungen der mit ihm verbundenen Objekte in einem Winkelbereich mit sehr hoher Dynamik und hoher Genauigkeit. Insbesondere zeichnet sich der erfindungsgemäße Drehsteller durch eine geringe Massenträgheit, eine hohe Antriebssteifigkeit und einen kompakten Aufbau aus.

Im Folgenden werden die Bereiche, an denen die Arme, die stabartigen Verbindungen oder die verdrillten Profile befestigt oder angelenkt sind, auch als Endbereiche, Befestigungsbereiche oder Segmente, die einzelnen Arme oder die einzelnen stabartigen Verbindungen oder die einzelnen verdrillten Profile auch als Elemente und die Gesamtheit der Elemente, die zwei Segmente miteinander verbinden auch als Trägerstruktur bezeichnet.

Im Folgenden soll der erfindungsgemäße Drehsteller anhand einiger Figuren beispielhaft erläutert werden. Gleiche Bezugszeichen entsprechen dabei gleichen oder analogen Elementen. Die in den Beispielen gezeigten Merkmale können erfindungsgemäß auch unabhängig vom konkreten Beispiel sein.

- Fig.1 zeigt einen erfindungsgemäßen Drehsteller mit einem hohlzylindrischen Drehwandler, dessen Trägerstrukturen aus streifenförmigen Armen bestehen, die bezüglich einer mittleren Äquatorebene symmetrisch angeordnet sind und die den Aktor umschließen.
- Fig.2 zeigt eine perspektivische Ansicht des Drehstellers aus Fig.1.
- Fig.3 zeigt eine Grafik des Drehwinkels für verschiedene Nullwinkel der Arme eines Drehwandlers.
- Fig.4 zeigt eine Grafik des Drehwinkels für verschiedene Durchmesser eines Drehwandlers.
- Fig.5 zeigt eine Grafik des Drehwinkels für verschiedene Abstände der ringförmigen Segmente eines Drehwandlers.
- Fig.6 zeigt eine in die Ebene abgewickelte Trägerstruktur eines zylindrischen Drehwandlers, dessen Arme direkt mit ringförmigen Segmenten verbunden sind.
- Fig.7 zeigt eine in die Ebene abgewickelte Trägerstruktur eines zylindrischen Drehwandlers, dessen Arme an den ringförmigen Segmenten mit Festkörpergelenken befestigt sind.
- Fig.8 a.) zeigt eine perspektivische Ansicht von Bestandteilen eines Drehstellers.

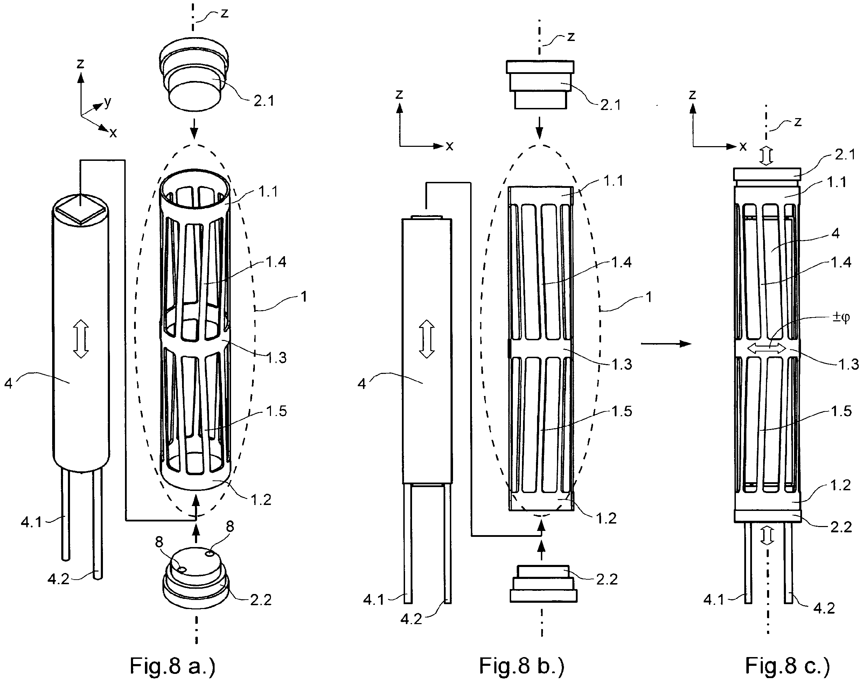

- Fig.8 b.) zeigt eine planare Ansicht von Bestandteilen eines Drehstellers.
- Fig.8 c.) zeigt einen Drehsteller im zusammengebauten Zustand, jedoch ohne Halter und ohne Nutzlast.

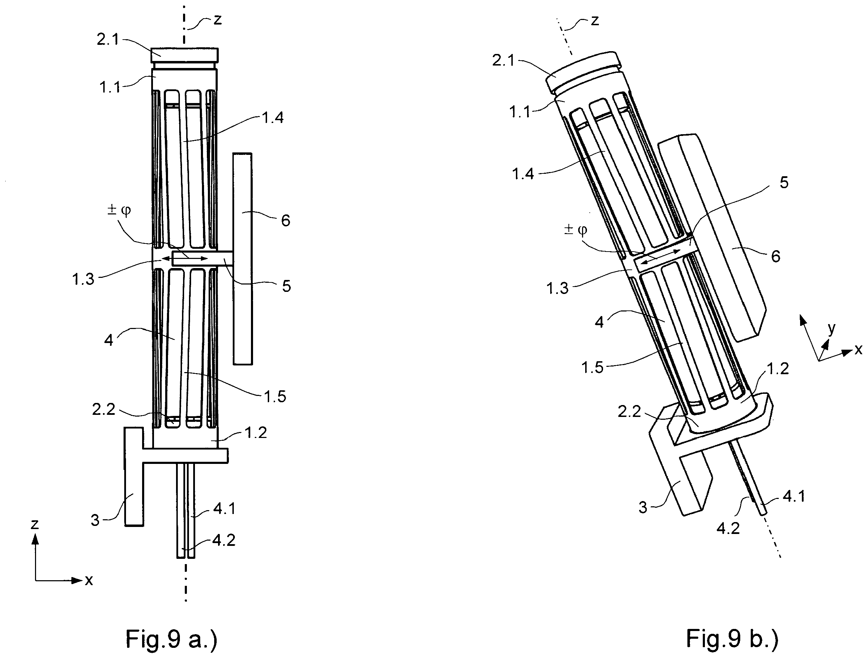

- Fig.9 a.) zeigt einen Drehsteller im zusammengebauten Zustand mit Halter und Nutzlast.
- Fig.9 b.) zeigt eine perspektivische Ansicht des Drehstellers aus Fig.9 a.).

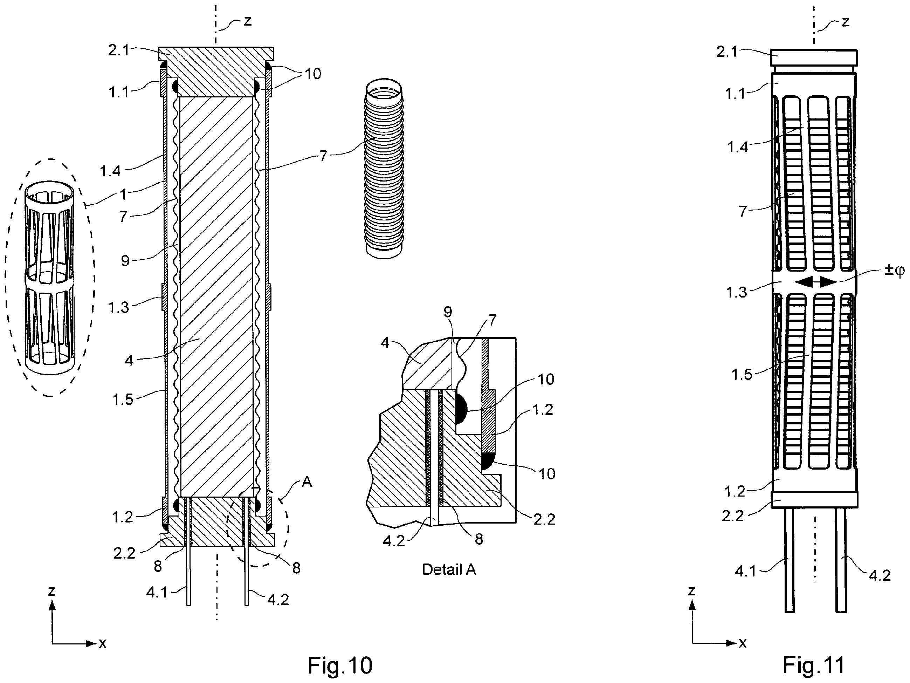

- Fig.10 zeigt eine Schnittdarstellung eines Drehstellers mit hermetisch gekapseltem Aktor.
- Fig.11 zeigt eine Ansicht des Drehstellers mit hermetisch gekapseltem Aktor aus Fig.10 im zusammengebauten Zustand.

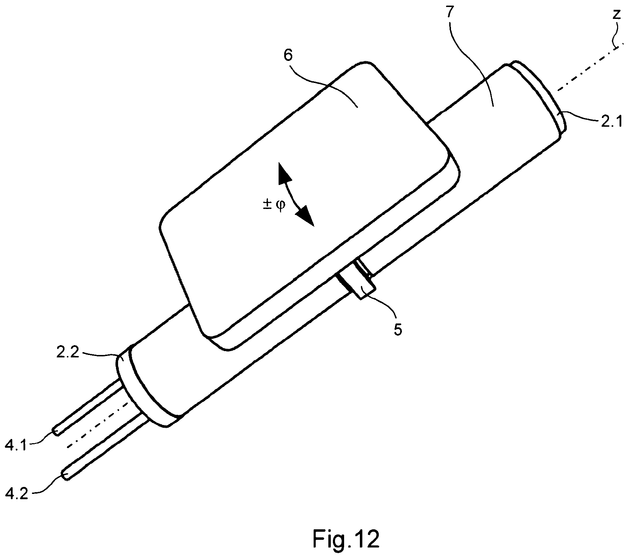

- Fig.12 zeigt eine perspektivische Abbildung eines Drehstellers mit einer äußeren hermetisch dichten Umhüllung.

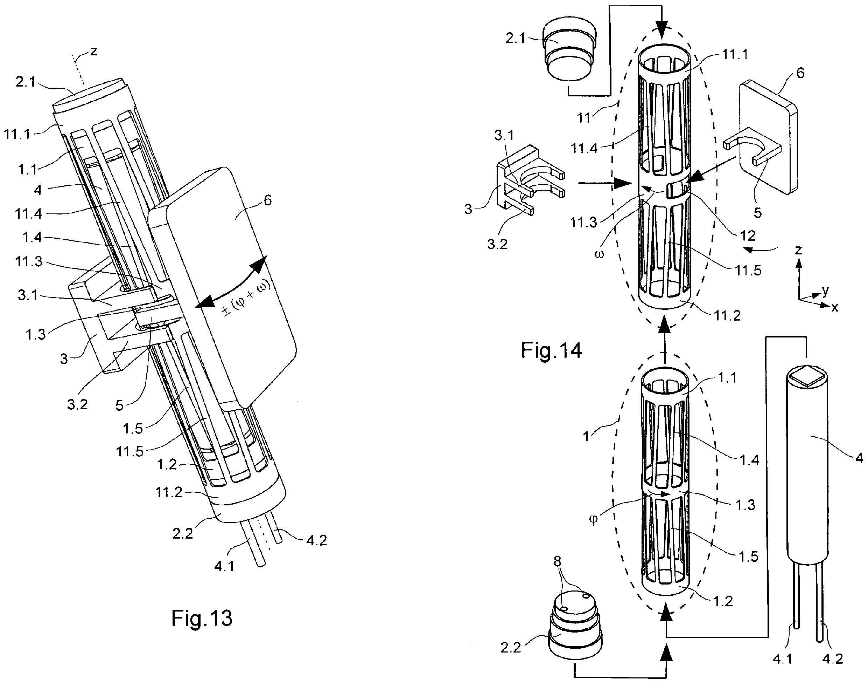

- Fig.13 zeigt eines perspektivische Ansicht eines Drehstellers mit doppeltwirkendem Drehwandler.
- Fig.14 zeigt eine Darstellung einzelner Bestandteile des doppeltwirkenden Drehstellers aus Fig.13.

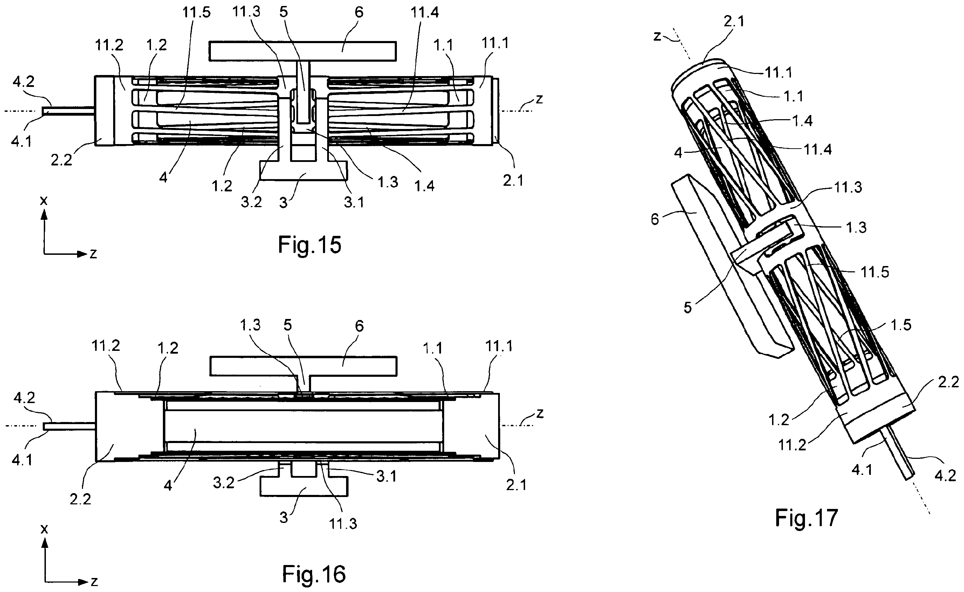

- Fig.15 zeigt eine Seitenansicht des Drehstellers aus Fig.13.
- Fig.16 zeigt eine Schnittdarstellung des Drehstellers aus Fig.13.
- Fig.17 zeigt eine perspektivische Abbildung des Drehstellers aus Fig.13 ohne Halter.

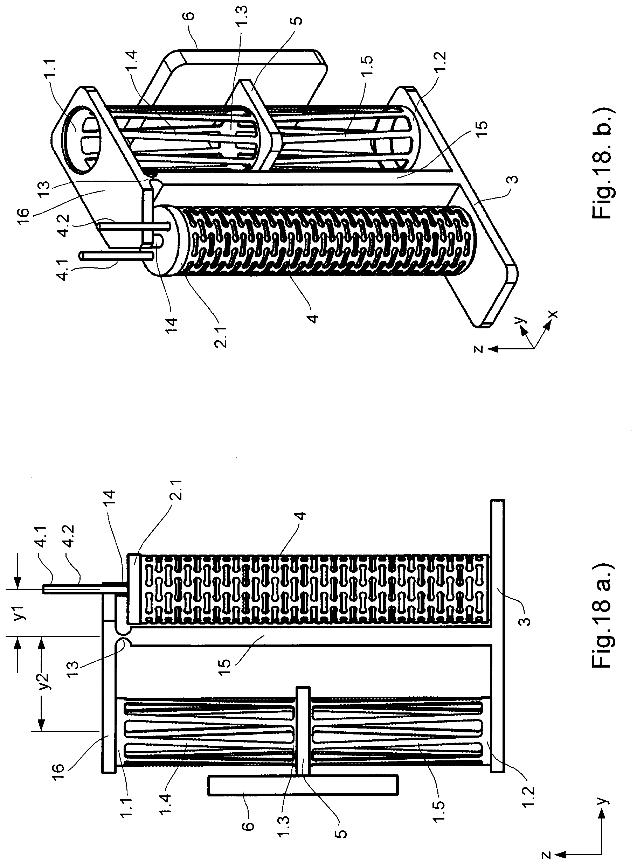

- Fig.18 a.) zeigt einen Drehsteller mit außenliegendem Drehwandler und Hebelübersetzung.
- Fig.18 b.) zeigt eine perspektivische Ansicht des Drehsteller aus Fig.18 a.).

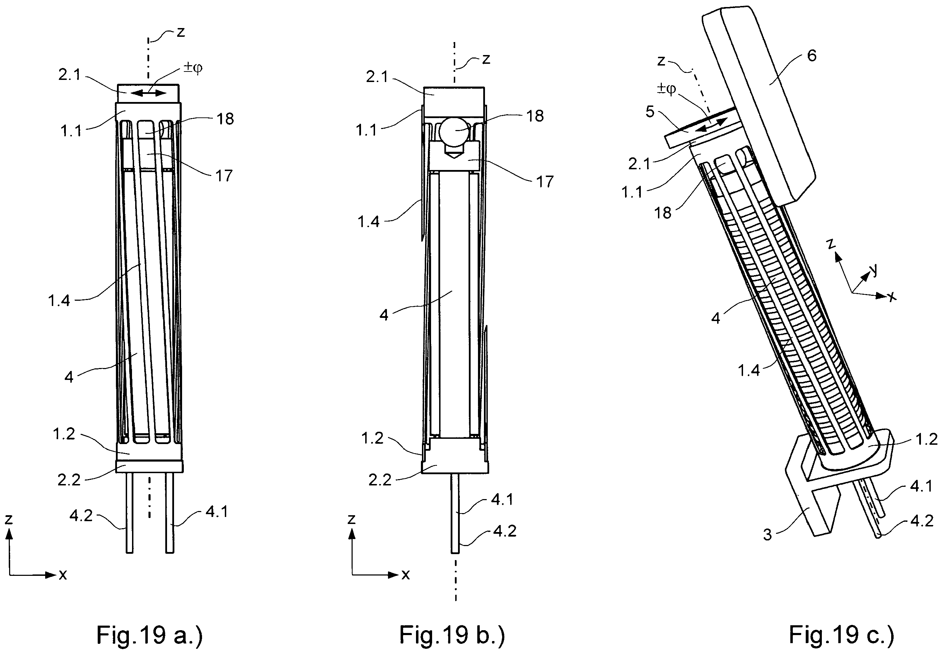

- Fig. 19 a.) zeigt einen nicht erfindungsgemäßen Drehsteller mit einem Drehwandler mit nur einer Trägerstruktur in seitlicher Ansicht.
- Fig.19 b.) zeigt eine Schnittdarstellung des in Fig.19 a.) gezeigten Drehstellers.
- Fig.19 c.) zeigt eine perspektivische Ansicht des in Fig.19 a.) gezeigten Drehstellers.

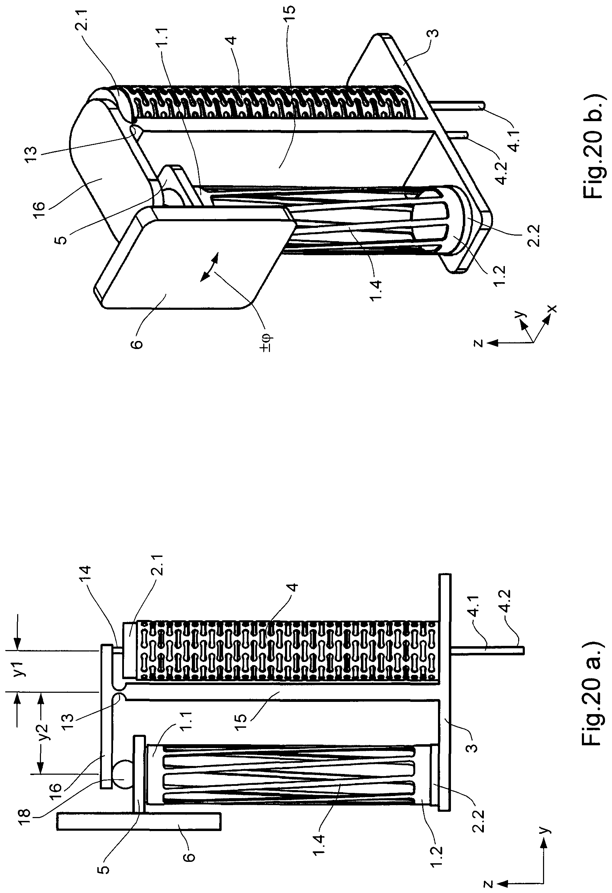

- Fig.20 a.) zeigt einen nicht erfindungsgemäßen Drehsteller mit außenliegendem und einseitig wirkendem Drehwandler und Hebelübersetzung.
- Fig.20 b.) zeigt eine perspektivische Ansicht des Drehstellers aus Fig.20 a.).

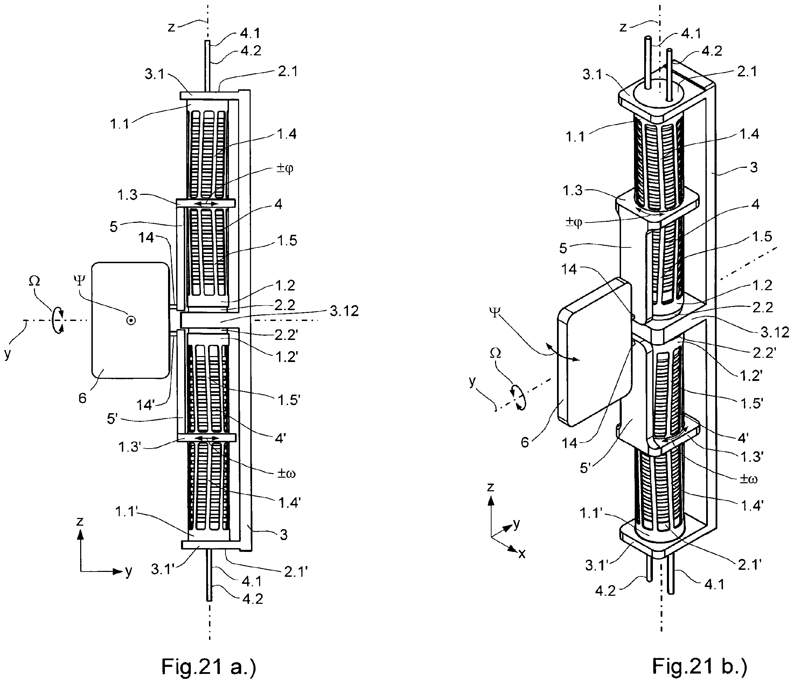

- Fig.21 a.) zeigt einen zweiachsigen Drehsteller.
- Fig.21 b.) zeigt eine perspektivische Ansicht des Drehstellers aus Fig. 21 a.).

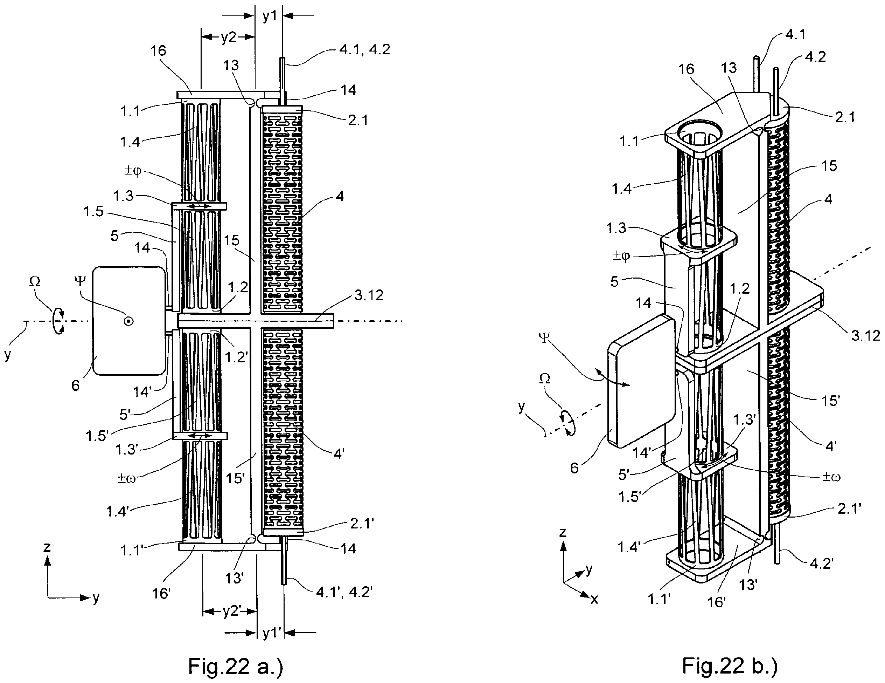

- Fig.22 a.) zeigt einen zweiachsigen Drehsteller mit außenliegenden Drehwandlern und Hebelübersetzung.
- Fig.22 b.) zeigt eine perspektivische Ansicht des Drehstellers aus Fig.22 a.).

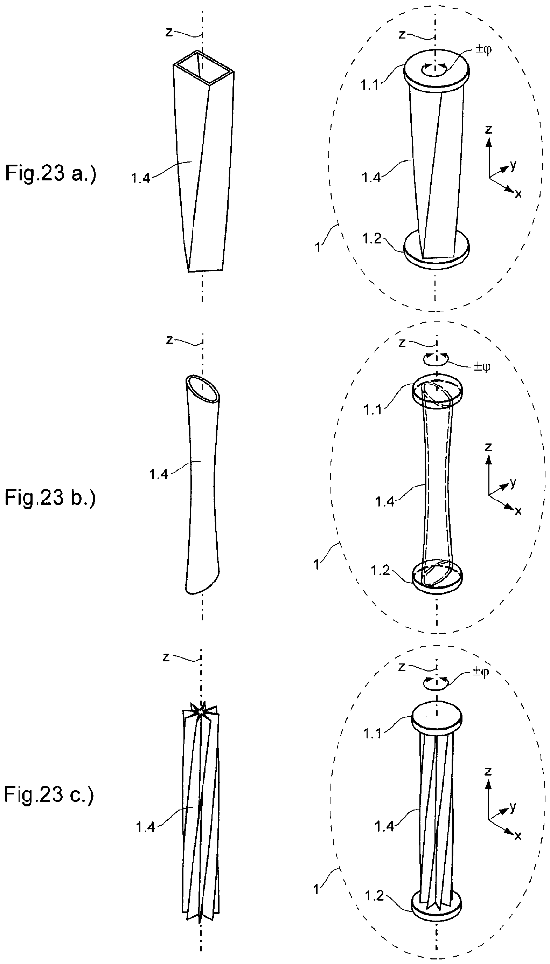

- Fig.23 a.) zeigt einen nicht erfindungsgemäßen Drehwandler mit einem kastenförmigem Hohlprofil als Trägerstruktur.
- Fig.23 b.) zeigt einen nicht erfindungsgemäßen Drehwandler mit elliptischem Hohlprofil als Trägerstruktur.
- Fig.23 c.) zeigt einen nicht erfindungsgemäßen Drehwandler mit sternförmigem Vollprofil als Trägerstruktur.

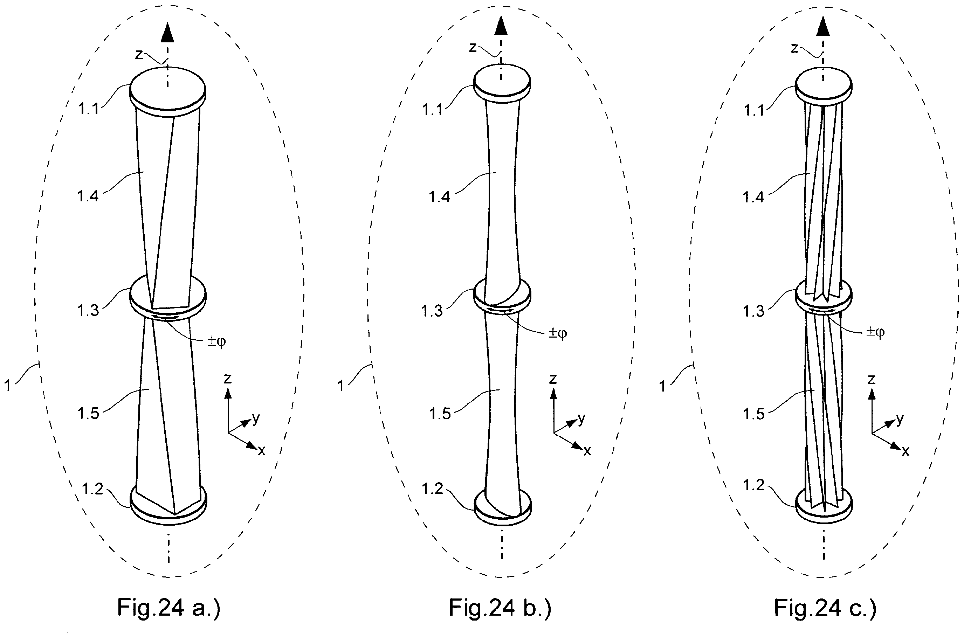

- Fig.24 a.) zeigt einen doppelt wirkenden Drehwandler mit zwei kastenförmigen Hohlprofilen als Trägerstrukturen.
- Fig.24 b.) zeigt einen doppelt wirkenden Drehwandler mit zwei elliptischen Hohlprofilen als Trägerstrukturen.
- Fig.24 c.) zeigt einen doppelt wirkenden Drehwandler mit zwei sternförmigen Vollprofilen als Trägerstrukturen.

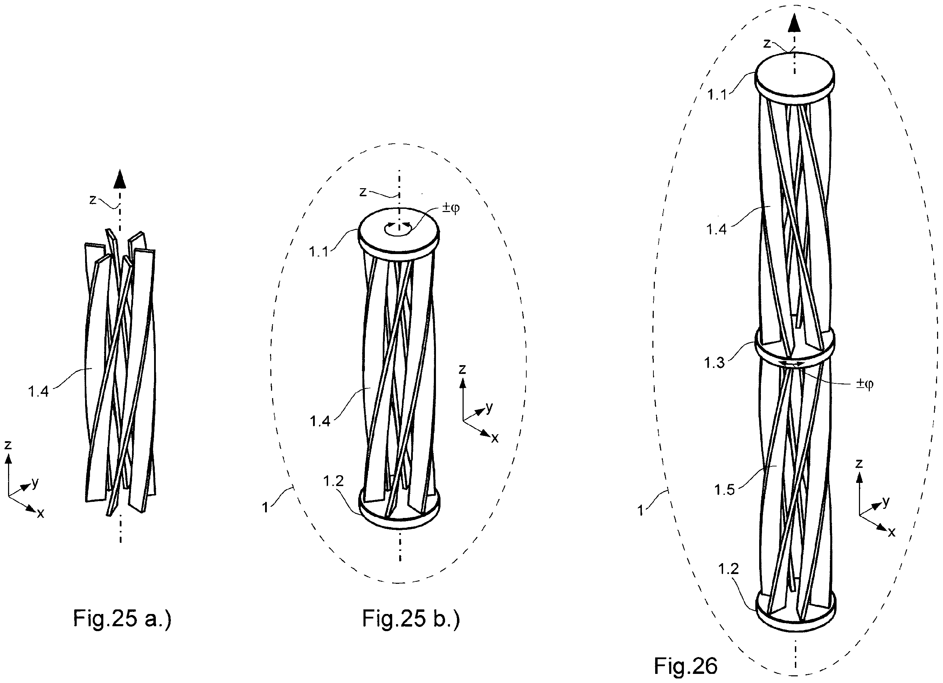

- Fig.25 a.) zeigt eine Trägerstruktur eines nicht erfindungsgemäßen Drehwandlers bestehend aus spiralförmig gebogenen Streifen.
- Fig.25 b.) zeigt einen nicht erfindungsgemäßen Drehwandler dessen Trägerstruktur aus spiralförmig gebogenen streifenförmigen Armen mit scheibenförmigen Segmenten verbunden ist.
- Fig.26 zeigt einen Drehwandler mit zwei Trägerstrukturen aus spiralförmig gebogenen streifenförmigen Armen, die bezüglich eines mittleren Segmentes spiegelsymmetrisch sind.

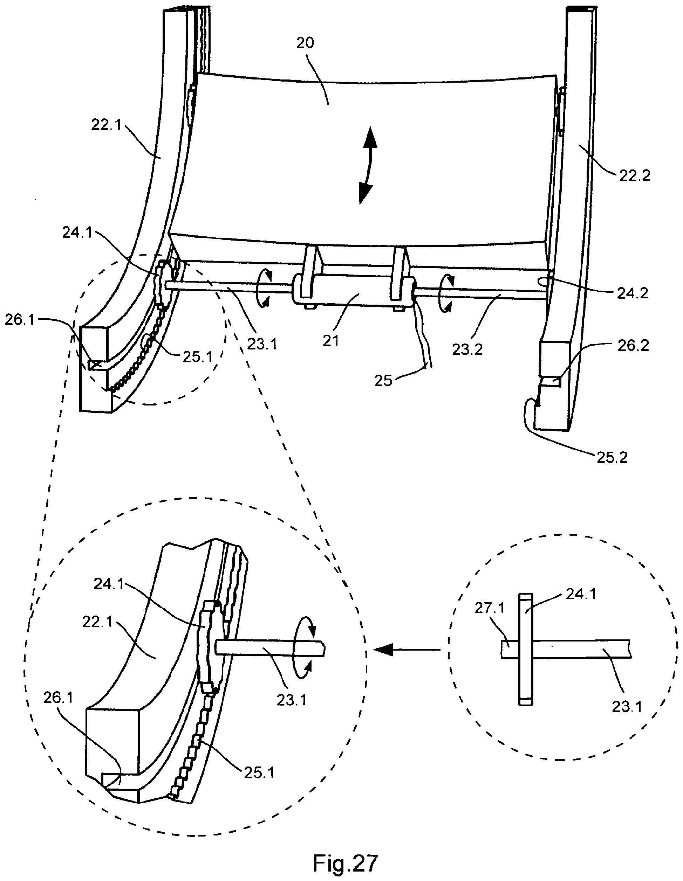

- Fig.27 zeigt ein Head-Up-Display (HUD) mit einem von einem mitfahrenden Elektromotor direkt angetriebenen Hauptspiegel (Combiner).

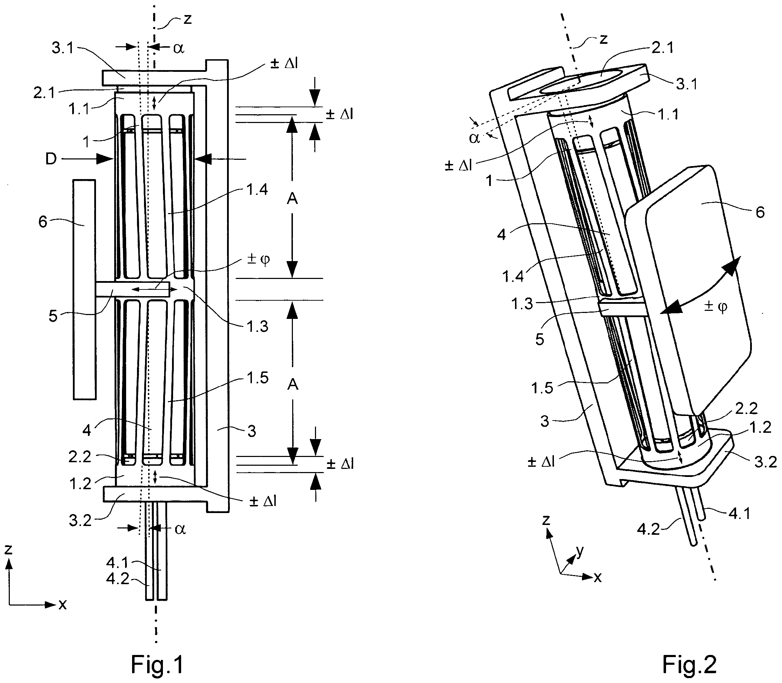

Als erstes Ausführungsbeispiel zeigt Fig.1 einen Drehsteller in Aufsicht. Fig.2 zeigt den Drehsteller aus Fig.1 in einer perspektivischen Ansicht. Der in Fig.1 und Fig.2 dargestellte Drehsteller weist als Drehwandler 1 eine hohlzylindrische um eine Längsachse z rotationssymmetrische Trägerstruktur, mit zwei endseitigen ringförmigen Segmenten 1.1 und 1.2 sowie einem mittleren ringförmigen Segment 1.3 auf. Die endseitigen Segmente 1.1, 1.2 sind mit dem mittleren Segment 1.3, auch als Äquatorbereich bezeichnet, durch Arme 1.4, 1.5 verbunden. Die Arme 1.4, 1.5 bilden eine äußere wandförmige Begrenzung des Drehwandlers 1 mit dem Durchmesser D. Die endseitigen Segmente 1.1, 1.2 sind von dem mittleren Segment 1.3 entlang der Längsachse z um das Maß A beabstandet. Die Arme 1.4, 1.5 sind in einer unbestromten Ausgangsstellung des Drehstellers auf dem Umfang des Drehwandlers 1 so orientiert, dass sie mit der auf den Umfang projizierten Längsachse z des Drehwandlers 1 einen Winkel α einschließen. Das mittlere Segment 1.3 liegt in einer zur Längsachse z des Drehwandlers 1 senkrechten Ebene, bezüglich derer die Arme 1.4, 1.5 spiegelbildlich angeordnet sind. Wie in Fig.1 und Fig.2 dargestellt, weisen die einzelnen Arme 1.4 untereinander auf dem Umfang des Drehwandlers 1 eine im wesentlichen parallele Orientierung auf. Ebenso sind die einzelnen Arme 1.5 auf dem Umfang des Drehwandlers 1 zueinander im wesentlichen parallel orientiert.

Der Drehwandler 1 kann an mindestens einem seiner endseitigen Segmente 1.1, 1.2 über Endkappen 2.1, 2.2 mit Laschen 3.1, 3.2 eines Halters 3 verbunden sein. Der Drehwandler 1 kann mit einem oder beiden endseitigen Segmenten mit dem Halter 3 verbunden sein. Bei der in Fig.1 beispielhaft dargestellten beidseitigen Befestigung des Drehwandlers 1 an den Laschen 3.1, 3.2 des Halters 3, sind diese insbesondere so ausgeführt, dass der Halter 3 mit seinen Laschen 3.1, 3.2 Längenänderungen des Drehwandlers 1 in Richtung der z-Achse einen möglichst geringen mechanischen Widerstand entgegensetzt. Hierzu kann eine der Endkappen 2.1, 2.2 des Drehwandlers in einer Führung des Halters 3 in z-Richtung verschiebbar gelagert sein und/oder die Laschen 3.1, 3.2 können aus biegeweichen Blechen bestehen und/oder der Halter 3 kann durch entsprechende Formgebung und/oder Materialwahl eine mechanische Nachgiebigkeit in Richtung der z-Achse aufweisen. Wesentlich für die Funktion des Drehwandlers 1 ist, dass sich dieser entlang der z-Achse längen und verkürzen kann. Insbesondere ist ein mit beiden endseitigen Segmenten 1.1, 1.2 verbundener Halter 3 so ausgeführt, dass diese Bewegung möglichst wenig behindert wird, der Drehwandler 1 aber drehsteif mit dem Halter 3 verbunden ist.

Zur Erzeugung axialer, in z-Richtung wirkender Kräfte auf die endseitigen Segmente 1.1, 1.2 des Drehwandlers 1, weist der Drehwandler 1 mindestens einen Aktor 4 auf, der sich in z-Richtung an mit den endseitigen Segmenten 1.1, 1.2 fest verbundenen Endkappen 2.1, 2.2 abstützen kann. Das Wirkprinzip des Aktors 4 kann beliebiger Art sein, solange dieser Kräfte auf die Segmente 1.1 und 1.2 des Drehwandlers 1 auszuüben in der Lage ist. Der Aktor 4 kann sich in einem inneren Hohlraum des Drehwandlers 1 befinden, so dass der Drehwandler 1 mit seiner Trägerstruktur den Aktor 4 umschließt, wie in Fig.1 und Fig.2 beispielhaft dargestellt.

Als Aktor 4 können alle Formen und Arten von Festkörperaktoren und elektromagnetischen Aktoren zur Anwendung kommen. Beispiele hierfür sind piezoelektrische, magnetostriktive, elektrostriktive, elektrostatische und dielektrische Aktoren sowie alle Arten von Elektromagneten. Bevorzugterweise ist der Aktor 4 ein elektrisch betätigbarer Aktor, wobei dieser elektrische Anschlüsse 4.1, 4.2 aufweisen kann. Der Aktor 4 kann jedoch auch ein durch andere physikalische Größen beeinflussbarer Aktor, z.B. ein Material mit einer thermischen Längen/Volumenänderung sein, z.B. ein Dehnstoff, oder ein Material, welches unter dem Einfluss äußerer elektrische Felder seine Form ändert. Derartige durch äußere Felder steuerbare Aktoren, benötigen die elektrischen Anschlüsse 4.1, 4.2 nicht notwendigerweise, jedoch können auch bei solchen Aktoren elektrische Anschlüsse, z.B. zur Erfassung sensorischer Eigenschaften, vorhanden sein.

Wird bei dem in Fig.1 und Fig.2 gezeigten Ausführungsbeispiel als Aktor 4 beispielsweise ein Material mit sehr hoher thermischer Längen/Volumenändernung verwendet, so werden die durch Änderungen der Temperatur hervorgerufenen Längenänderungen des Aktors 4 in Richtung der z-Achse in temperaturproportionale Drehungen des mittleren Segmentes 1.3 gegenüber den endseitigen Segmenten 1.1, 1.2 umgesetzt. Ein solcher Drehsteller kann zur temperaturgesteuerten Betätigung von Einrichtungen, z.B. Ventilen, Verriegelungs/Entriegelungseinrichtungen, z.B. Feuerschutztüren, sonstigen Schließmechanismen oder auch zur Temperaturanzeige dienen.

Insbesondere hat der Drehwandler 1 die Eigenschaften einer Feder, die sich bei in Richtung der z-Achse wirkenden Zug- oder Druckkräften längt oder verkürzt, wobei sich Querschnitte des Drehwandlers gegeneinander verdrehen. Aufgrund der Federwirkung des Drehwandlers 1 kann dieser dazu dienen, den Aktor 4 unter einer mechanischen Vorspannung mit dem Drehwandler 1 zu verbinden. Die Federwirkung des Drehwandlers 1 kann durch Formgestaltung der Arme und/ oder Veränderung der Anzahl und der Länge der Arme eingestellt werden. Insbesondere können die Arme auf dem Umfang des Drehwandlers eine geschwungene oder gerade stabartige Form haben, oder durch Aufwickeln von planaren Strukturen um eine Achse gebildet werden und/oder Gelenke, insbesondere Festkörpergelenke, aufweisen.

Ein sehr großes Anwendungsfeld ergibt sich für Drehwandler der erfindungsgemäßen Art in Verbindung mit elektrisch steuerbaren Aktoren, die durch Anlegen elektrischer Signalspannungen an die Anschlüsse 4.1, 4.2 auf die endseitigen Segmente 1.1 und 1.2 des Drehwandlers 1 proportionale Kräfte ausüben und diesen entlang der z-Achse um Beträge $\pm\Delta 1$ dehnen und/oder stauchen können. Ein solcher Aktor kann beispielsweise ein Elektromagnet sein, der innerhalb oder ausserhalb des Drehwandlers 1 angeordnet ist und der bei Bestromung in Richtung der z-Achse wirkende Kräfte entweder über die Endkappen 2.1, 2.2 oder direkt auf die endseitigen Segmente 1.1, 1.2 ausübt. Insbesondere eignen sich piezolektrische Aktoren für den erfindungsgemäßen Drehwandler, da diese sehr hohe Kräfte zu erzeugen in der Lage sind, elektrisch einfach steuerbar sind und im statischen Betrieb nahezu keine elektrische Leistung aufnehmen. Ohne Beschränkung der Allgemeinheit wird zur Darstellung des Wirkprinzipes und weiterer Ausführungsbeispiele des erfindungsgemäßen Drehwandlers aus Gründen der Klarheit der Darstellung im Folgenden davon ausgegangen, dass es sich bei dem Aktor 4 um einen piezoelektrischen Aktor, insbesondere einen piezoelektrischen Stapelaktor (Piezomultilayerstack) handelt, der bei Anlegen elektrischer Signalspannungen an die Anschlüsse 4.1, 4.2 Längenänderungen bevorzugt in Richtung der z-Achse des Drehwandlers 1 ausführen kann.

Die Gesamtheit von Drehwandler und Aktor wird auch als Drehsteller bezeichnet.

Der Aktor 4 kann innerhalb oder ausserhalb des Drehwandlers 1 angeordnet sein und/oder den Drehwandler 1 umschließen. Insbesondere kann der Aktor 4, wie in Fig.1 und Fig.2, in einem inneren Hohlraum des Drehwandlers 1 angeordnet sein. Insbesondere stützt sich der Aktor 4 in z-Richtung an Endkappen 2.1, 2.2 ab, die mit den endseitigen Segmenten 1.1, 1.2 fest verbunden sind, so dass sich axiale Bewegungen des Aktors 4 in z-Richtung über die Endkappen 2.1, 2.2 auf die Trägerstruktur des Drehwandlers 1 übertragen. Der Halter 3 ist mit seinen Laschen 3.1, 3.2 bevorzugt so ausgeführt, dass er dieser Bewegung einen nur geringen oder bei einseitiger Halterung, überhaupt keinen mechanischen Widerstand entgegensetzt. Aufgrund der mechanischen Federwirkung des Drehwandlers 1, kann dieser gleichzeitig die Funktion einer Vorspannfeder für den Aktor 4 übernehmen. Dieses ist insbesondere bei Festkörperaktoren, beispielsweise piezoelektrischen Aktoren vorteilhaft. Hierzu kann der Drehwandler 1 durch äußere Hilfsmittel auf den gewünschten Wert der Vorspannkraft gelängt, die Endkappen 2.1, 2.2 und der Piezoaktor 4 in den Drehwandler 1 eingesetzt und die Endkappen 2.1, 2.2 in dieser Stellung mit den ringförmigen Bereichen 1.1, 1.2 des Drehwandlers fest verbunden werden, z.B. durch Schweißen, Pressen, Verkleben oder Verschrauben.

Als zu drehendes Objekt weist der Drehwandler eine Nutzlast 6 auf, z.B. einen Spiegel oder ein Werkzeug, die über ein Verbindungselement 5 fest mit dem Segment 1.3 des Drehwandlers 1 verbunden ist.

Die Drehung einer Nutzlast 6 um einen Winkelbetrag um die z-Achse, kann durch Anlegen einer elektrischen Signalspannung an die Anschlüsse 4.1, 4.2 des Aktors 4 bewirkt werden. Die von dem Aktor 4 dadurch auf die endseitigen Segmente 1.1, 1.2 in z-Richtung ausgeübten Kräfte dehnen oder verkürzen die Trägerstruktur des Drehwandlers 1, abhängig von der Amplitude und dem Betrag der elektrischen Ansteuerspannung, in z-Richtung, wodurch die Segmente 1.1, 1.2 ihren Abstand A in z-Richtung vergrössern oder verringern. Eine Dehnung des Drehwandlers 1 in z-Richtung führt zu einer Verkleinerung des Winkels a, den die Arme 1.4, 1.5 auf dem Umfang des Drehwandlers 1 mit der auf den Umfang des Drehwandlers parallelprojizierten z-Achse bilden, was zu einer der Winkeländerung von $\alpha$ proportionalen Drehung des, auch als Äquatorbereich bezeichneten, mittleren Segmentes 1.3 um den Betrag +$\varphi$ um die z-Achse bezüglich der endseitigen Segmente 1.1, 1.2 des Drehwandlers 1 führt.

Zur Übertragung der Drehung des mittleren Segmentes 1.3 auf eine Nutzlast 6, beispielsweise einen Projektionsspiegel, dient ein Verbindungselement 5, welches die Nutzlast 6 mit dem mittleren Segment 1.3 verbindet.

Analog führt eine Stauchung des Drehwandlers 1 zu einer Vergrößerung des Winkels a, den die Arme 1.4, 1.5 auf dem Umfang des Drehwandlers 1 mit der z-Achse bilden und somit zu einer im Vergleich zur Dehnung des Drehwandlers 1 gegensinnigen Drehung des mittleren Segmentes 1.3 und der mit ihm verbundenen Nutzlast 6 gegenüber der endseitigen Segmente 1.1, 1.2 um den Betrag -$\varphi$. Die Ebene der Drehungen ±$\varphi$ der Segmente liegt dabei senkrecht zur z-Achse des Drehwandlers 1. Die Funktionen von Halter und Nutzlast sind grundsätzlich vertauschbar.

Der in den Fig.1 und Fig.2 beschriebene erfindungsgemäße Drehsteller gestattet eine schlanke, kompakte und annähernd zylindrische Bauform. Der Drehwandler 1 kann jedoch auch Bereiche oder Segmente 1.1, 1.2, 1.3 unterschiedlichen Durchmessers aufweisen. Beispielsweise kann das auch als Äquatorbereich bezeichnete mittlere Segment 1.3 gegenüber den auch als endseitigen Bereichen bezeichneten Segmenten 1.1, 1.2 einen größeren Durchmesser besitzen, was in Verbindung mit einem Aktor 4 kurzer Baulänge zu einer flachen Bauform führt oder die endseitigen Bereiche 1.1, 1.2 haben gegenüber dem Äquatorbereich 1.3 einen größeren Durchmesser. Insbesondere müssen die Durchmesser der verschiedenen Segmente oder Bereiche, die Winkel welche die verschiedenen Arm- oder Trägerstrukturen auf dem Umfang mit der z-Achse bilden sowie die Längen der verschiedenen Arm- oder Trägerstrukturen nicht identisch sein, sondern es muss lediglich ein Drehsinn sichergestellt sein, so dass durch einen Aktor hervorgerufene Dehnungen und Stauchungen des Drehwandlers 1 zu Relativdrehungen der verschiedenen Segmente oder ringförmigen Bereiche des Drehwandlers 1 führen.

Die erfindungsgemäße Struktur des Drehwandlers 1 setzt Längenänderungen des Drehwandlers 1 effektiv in Drehbewegungen um.

Durch geeignete Wahl der Armwinkel a, der Beabstandung A und des Durchmessers D, siehe Fig.1 und Fig.2, kann der Drehwandler so dimensioniert werden, dass kleine Längenänderungen in große Drehwinkelbewegungen umgesetzt werden. Die Wahl der Parammter a, A, D sowie der Wanddicke und der Armformen ergeben einen großen Auslegungsspielraum, so dass der erfindungsgemäße Drehsteller an eine Vielzahl von Aktoren und Anforderungen angepasst werden kann.

Das geringe Massenträgheitsmoment und die hohe Steifigkeit des Drehwandlers 1 ermöglichen eine hohe Dynamik des Drehstellers bei gleichzeitig hoher Genauigkeit.

Für einen zylindrischen Drehwandler 1 der in Fig.1 und Fig.2 beispielhaft dargestellten Bauart gilt näherungsweise folgende Beziehung zwischen dem Drehwinkel $\varphi$ als Funktion der Abstandsänderung ±$\Delta$l der endseitigen ring-

förmigen Bereiche 1.1, 1.2 vom Äquatorbereich 1.3:

$$\pm\varphi\ [\text{Grad}]=\ \ 360\cdot(A/(\pi\cdot D))\cdot[\text{SQRT}((1/\cos\alpha)^2-1)-\ \ \ \ \ \ \ \ \ \ (\text{Gl.1})$$

$$\text{SQRT}(((1/\cos\alpha)^2)-(1\pm\Delta l/A)^2]$$

mit den bereits in Fig.1 und Fig.2 verwendeten Bezeichnungen:

$\pm\Delta l$    - Abstandsänderung eines endseitigen ringförmigen Bereiches 1.1, 1.2 vom Äquatorbereich 1.3

A       - Nullabstand (Aktor unbestromt) der endseitigen ringförmigen Bereiche 1.1, 1.2 vom Äquatorbereich 1.3

D       - Durchmesser des Drehwandlers 1

$\alpha$       - Nullwinkel (Aktor unbestromt) der Arme 1.4, 1.5 auf dem Umfang des Drehwandlers zur auf den Umfang parallelprojizierten z-Achse des Drehwandlers 1

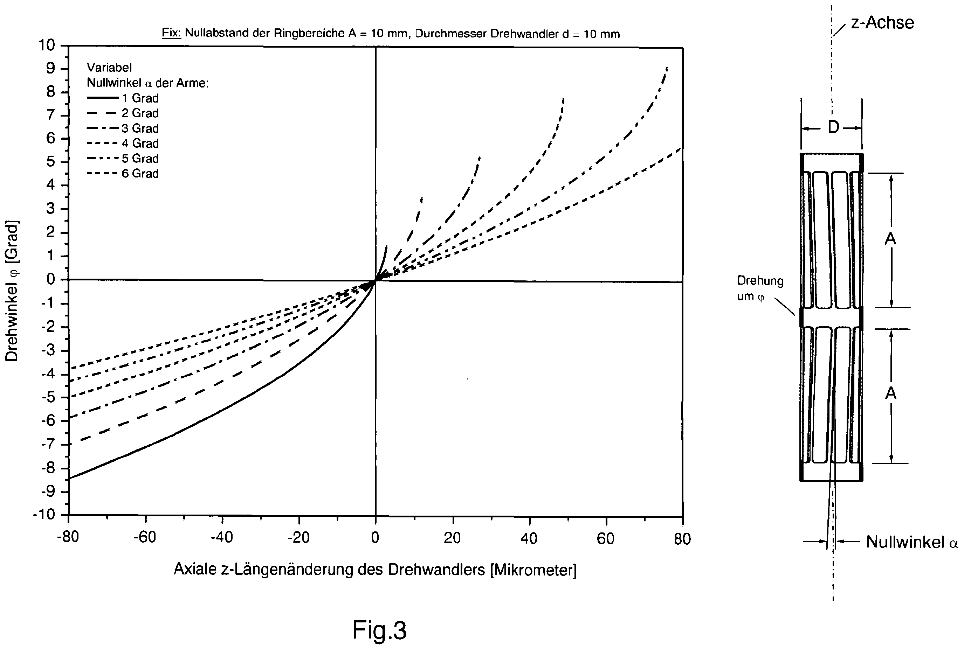

Fig.3 zeigt den nach Gl.1 berechneten Drehwinkel $\varphi$ als Funktion der Längenänderung des Drehwandlers bei vorgegebenem Nullabstand von A = 10 mm und vorgegebenem Durchmesser des Drehwandlers von D = 10 mm für verschiedene Nullwinkel $\alpha$ der Arme. Die Empfindlichkeit des Drehwinkels $\pm\varphi$ auf axiale Längenänderungen $\pm\Delta l$ nimmt mit abnehmendem Nullwinkel $\alpha$ der Arme zu. Bei Zugkräften ist der Drehwinkelbereich mit abnehmendem Nullwinkel $\alpha$ der Arme jedoch eingeschränkt, da die dann bereits in der Nullage fast senkrecht zur Zugrichtung stehenden Arme nur eine kleine Verschiebung auf dem Umfang des Drehwandlers ausführen können. Mit zunehmendem Nullwinkel $\alpha$ der Arme verringert sich der Verstärkungsfaktor mit dem Längenänderungen des Drehwandlers in Drehungen umgesetzt werden. Selbst für Längenänderungen von einigen 10 Mikrometern lässt sich jedoch immer noch ein sehr großer Drehwinkelbereich überstreichen.

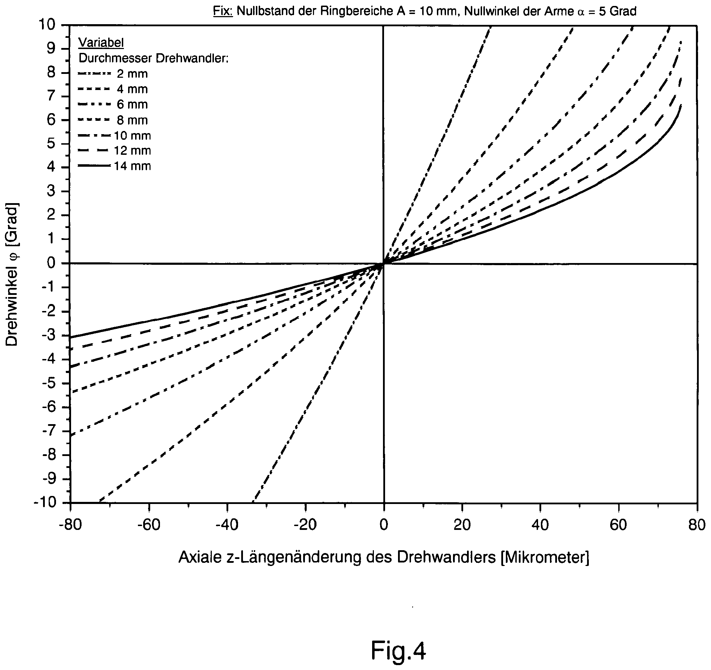

Den Einfluss des Durchmessers D des Drehwandlers auf den Drehwinkel $\varphi$ bei vorgegebenem Abstand A = 10 mm und vorgegebenem Nullwinkel der Arme von $\alpha$ = 5° zeigt Fig.4. Axiale Längenänderungen $\pm\Delta l$ des Drehwandlers werden, entsprechend Gl.1.1 und wie Fig.4 zeigt, umso effizienter in Drehbewegungen umgesetzt, je geringer der Durchmesser D des Drehwandlers ist. Für einen Drehwandler mit dem Durchmesser D = 10 mm und einer Längenänderung um 40 $\mu$m beträgt der Drehwinkel 3,1°. Aufgrund der 1/D Proportionalität des Drehwinkels eignen sich insbesondere auch verdrillte stabförmige Strukturen für den erfindungsgemäßen Drehwandler.

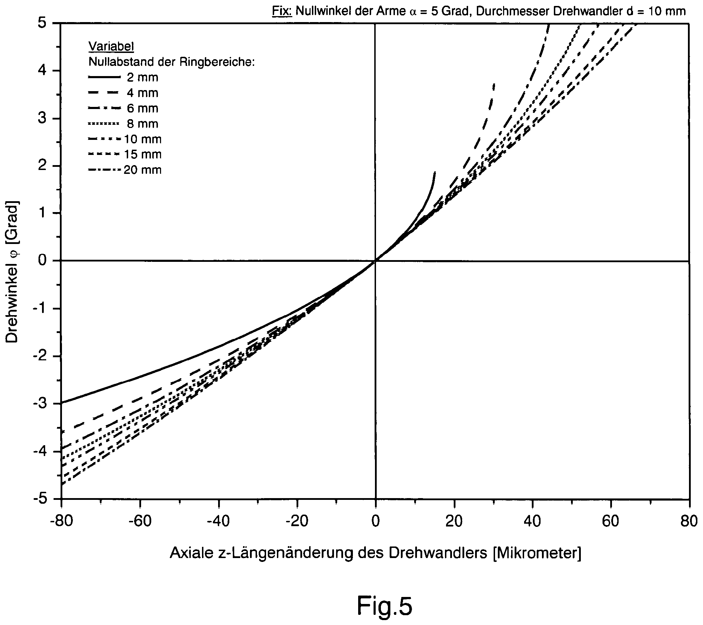

Fig.5 zeigt den Einfluss des Nullabstands A der ringförmigen Bereiche auf die Drehwinkelcharakteristik. Aufgrund der Versteifung des Drehwandlers und aus mechanischen Stabilitätsgründen ist eine Auslegung mit nicht zu kurzen Armlängen zu bevorzugen.

Gl.l beweist die Wirksamkeit des erfindungsgemäßen Drehwandlers und zeigt dessen besondere Eignung zur Umsetzung longitudinaler Längenänderungen in Drehwinkeländerungen.

Der Drehwandler 1 kann, wie in Fig.1, eine zylindrische Struktur aufweisen mit der z-Achse als Symmetrieachse. Die Abwickelbarkeit derartiger Strukturen ergibt herstellungstechnische Vorteile, da sie die Herstellung des Drehwandlers aus planaren Strukturen ermöglicht. Insbesondere kann die Struktur des erfindungsgemäßen Drehwandlers kostengünstig und in hohen Stückzahlen durch Stanzen, z.B. aus einem Federblech, erzeugt und der Drehwandler durch Aufrollen um die z-Achse und anschließende Verbindung der Enden/Stoßkanten zu einem zylindrischen Körper hergestellt werden. Als Verbindungstechniken eignen sich insbesondere Schweiss-, Falz- und Klebeprozesse. Der Drehwandler kann jedoch auch mittels mechanischer, chemischer, elektrochemischer, Spritzgiess- oder Laserverfahren z.B. durch Laserstrukturierung, elektrisches Erodieren, Fräsen, Drehen oder Naß- und/oder Trockenätzen hergestellt werden.

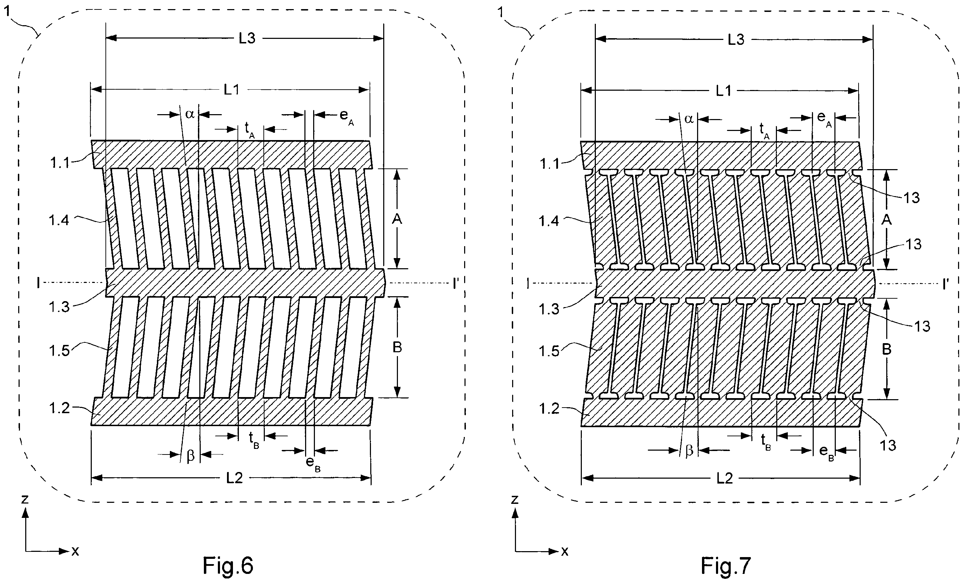

Fig.6 zeigt einen zylindrischen Drehwandler, der am Umfang entlang seiner z-Symmetrieachse aufgetrennt und in die xz-Ebene abgewickelt wurde. Die in Fig.6 dargestellte planare Drehwandlerstruktur kann in verschiedenen Bereichen entlang der zur xz-Achse senkrechten y-Achse, unterschiedliche Dicken aufweisen. Der in die Ebene abgewickelte Drehwandler 1 gemäß Fig.6 weist zwei endseitige streifenförmige Bereiche 1.1, 1.2 und einen mittleren streifenförmigen Äquatorbereich 1.3 auf. Die Bereiche 1.1 und 1.3 sind entlang der z-Achse um das Maß A voneinander beabstandet und durch Arme 1.4 miteinander verbunden, die bezüglich der z-Achse in einem Winkel $\alpha$ orientiert sind. Ebenso sind die Bereiche 1.2 und 1.3 entlang der z-Achse um das Maß B voneinander beabstandet und durch Arme 1.5 miteinander verbunden, die bezüglich der z-Achse in einem Winkel $\beta$ orientiert sind. Insbesondere weist die Struktur des in Fig.6 gezeigten Drehwandlers 1 eine Spiegelsymmetrie bezüglich einer in x-Richtung orientierten Mittelachse I-I' auf, so dass $|\alpha|=|\beta|$. Hierdurch ergibt sich in Bezug auf die Symmetrieachse I-I' eine fischgrätenartige Struktur. Weist der Drehwandler eine zylindrische Form auf, sind die Längen L1, L2, L3 der streifenförmigen Bereiche 1.1, 1.2, 1.3 identisch. Die Arme 1.4 besitzen die Breite $e_A\cdot\cos(\alpha)$ und sind im Abstand $t_A$ längs der x-Achse angeordnet. Die Arme 1.5 besitzen die Breite $e_A\cdot\cos(\beta)$ und sind längs der x-Achse im Abstand $t_B$ angeordnet. Die in Fig.6 abgebildete planare Drehwandlerstruktur, kann um die z-Achse zu einem zylindrischen Körper mit dem Durchmesser D=(L/$\pi$) aufgewickelt werden, mit L=L1=L2=L3.

Die hohe Symmetrie der in Fig.6 gezeigten Drehwandlerstruktur bietet herstellungstechnische und funktionale Vorteile. Die erfindungsgemäße Idee ist jedoch auch auf Strukturen mit anderer und/oder niedrigerer Symmetrie anwendbar. Beispielsweise ergeben sich für (L1=L2)≠L3 oder (L1=L3)≠L2 oder (L2=L3)≠L1 oder L1≠L2≠L3 kegelartige Formen des Drehwandlers. Durch unterschiedliche Winkel $\alpha$ und $\beta$, durch unterschiedliche Abstände A und B, durch unterschiedliche Teilungen $t_A$ und $t_b$, durch unterschiedliche, z.B. geschwungene, Formen der Arme 1.4, 1.5 sowie unterschiedliche Breiten der Arme 1.4, 1.5 ergibt sich eine große Variantenvielfalt und Auslegungsbandbreite des erfindungsgemäßen Drehwandlers.

Um geringe Kräfte und/oder Auslenkungen des Aktors 4 in große Drehbewegungen umzusetzen ist es vorteilhaft, wenn die Arme 1.4, 1.5 in ihrer Längsrichtung eine niedrige Dehnung jedoch in Bezug auf Verschiebungen auf dem Umfang des Drehwandlers um die z-Achse eine hohe Biegeweichheit aufweisen. Wie in Fig.7 dargestellt kann dieses durch Verbindung der Arme 1.4, 1.5 mit den ringförmigen oder streifenförmigen Bereichen 1.1, 1.2, 1.3 über Festkörpergelenke 13 erreicht werden. Die in Form von Einschnürungen (Breite, Dicke, Länge) der Arme 1.4, 1.5 ausgestalteten Festkörpergelenke 13 setzen Drehbewegungen der ringförmigen Bereiche beziehungsweise Verschiebebewegungen auf dem Umfang des Drehwandlers einen nur geringen mechanischen Widerstand entgegen. Gegenüber der Breite $(t_B - e_B)$ und $(t_A - e_A)$ der Festkörpergelenke 13 können die Arme 1.4, 1.5 selbst eine größere Breite und damit eine hohe Dehnungssteifigkeit besitzen. Zugleich kann die Dicke der Armstruktur im Bereich der Festkörpergelenke verringert sein. Anstelle von Festkörpergelenken können auch klassische Formen von Lagerungen wie Kugellager, Nadellager, Gleitlager etc. zur Anwendung kommen.

Fig.8 a.) und Fig.8 b.) zeigen einzelne Komponenten des erfindungsgemäßen Drehstellers sowie deren Anordnung in perspektivischer und planarer Ansicht. Dieser kann ringförmige Bereiche 1.1, 1.2, 1.3, Arme 1.4, 1.5, eine Kopfplatte 2.1, eine Fußplatte 2.2 mit Durchführungen 8, einen Aktor 4 mit elektrischen Anschlüssen 4.1, 4.2 aufweisen. Fig.8 c.) zeigt einen zusammengebauten Drehsteller, jedoch ohne Halter und ohne Nutzlast.

Die Funktion des Drehwandlers beruht auf Relativdrehungen der einzelnen ringförmigen Bereiche des Drehwandlers um die z-Achse. Bei dem Ausführungsbeispiel gemäß Fig.1 verdreht sich bei einer Längenänderung des Drehwandlers der Äquatorbereich 1.3 relativ zu den endseitigen ringförmigen Bereichen 1.1, 1.2. Die Funktionen von Halter 3 und Nutzlast 6 sind bei dem erfindungsgemäßen Drehsteller, insbesondere bei allen dargestellter Ausführungsformen vertauschbar und lediglich eine Frage der Festlegung des Inertialsystemes. In Fig.1 kann die Nutzlast 6 beispielsweise auch an die endseitigen Bereiche 1.1, 1.2 angekoppelt und der Äquatorbereich 1.3 stationär befestigt sein.

Fig.9 a.) und Fig.9 b.) zeigen zwei Ansichten eines Drehstellers, der mit dem Halter 3 nur einseitig verbunden ist. Auch hier können die Funktionen von Halter 3 und Nutzlast 6 miteinander vertauscht werden, d.h. der Drehwandler 1 kann auch am Äquatorbereich 1.3 mit einem ortsfesten Gehäuse verbunden sein und die Nutzlast anstelle des Halters 3 an dem Drehwandler befestigt sein.

Für die Betriebsstabilität eines Aktors 4 kann es vorteilhaft sein, diesen gegenüber Umwelteinflüssen, insbesondere Feuchtigkeit, zu schützen. Hierzu kann der erfindungsgemäße Drehsteller als weiteres Element eine Schutzhülle 7 aufweisen, die den Aktor 4 in Form einer Ummantelung umschließt und hermetisch abdichtet, so wie dies die Fig.10 in einer Schnittansicht zeigt. Fig.11 zeigt den Drehsteller aus Fig.10 in einer Außenansicht.

Der in Fig.10 und in Fig.11 dargestellte Drehsteller weist einen elektrischen Aktor 4 mit elektrischen Anschlüssen 4.1, 4.2, eine balgartige Struktur 7, einen Drehwandler 1, eine Kopfplatte 2.1 sowie eine Fußplatte 2.2 mit elektrisch isolierten Durchführungen 8 auf. Eine mechanische Nachgiebigkeit der Schutzhülle 7 in Richtung der z-Achse wird beispielsweise durch eine gewellte Wandstruktur erreicht, wie anhand der balgartigen Struktur 7 in Fig.10 veranschaulicht. Der Aktor 4 liegt stirnseitig bündig, vorteilhafterweise unter einer mechanischen Vorspannung, an der Kopfplatte 2.1 und an der Fußplatte 2.2 an. Die mechanische Vorspannung kann von dem Drehwandler 1 und/oder dem Balg 7 aufgebracht werden. Die mechanische Verbindung der Elemente ist symbolhaft durch Schweiss- und/oder Klebenähte 10 angedeutet. Hierfür sind jedoch auch andere Verbindungstechniken geeignet. Die Detailansicht A in Fig.10 zeigt die mechanischen Verbindungen der Fußplatte 2.2 mit dem Drehwandler 1 und dem Balg 7 durch Schweiss- oder Klebenähte 10 sowie die elektrischen Durchführungen 8 der Anschlussstifte 4.1, 4.2 des Aktors 4. Bei dem in Fig.10 gezeigten Ausführungsbeispiel, ist der Aktor 4 durch einen sich im Inneren des Drehwandlers 1 befindlichen und den Aktor 4 umschließenden Balg 7 hermetisch abgedichtet. Hierzu ist der Balg 7 an seinen Enden mit Endplatten 2.1, 2.2 hermetisch dicht verbunden. Eine mechanische und hermetisch dichte Verbindung des Balgs 7 mit den Endkappen 2.1, 2.2 kann durch bekannte Verfahren wie z.B. Schweißen, Kleben, Pressen oder mittels elastomerer Dichtelemente, wie beispielsweise O-Ringe, erzielt werden. Zur Verbindung der endseitigen ringförmigen Bereich 1.1, 1.2 des Drehwandlers 1 stehen eine Vielzahl bekannter Verbindungs- und Fügetechniken zur Verfügung. Zur Gewährleistung einer hermetischen Abdichtung sind die Durchführungen 8 der elektrischen Anschlüsse 4.1, 4.2 durch die Endplatte 2.2 ebenfalls hermetisch abgedichtet, wie dies die Detailansicht A in Fig.10 zeigt. Das Dichtmittel 8 kann gleichzeitig die Funktion eines elektrischen Isolators haben. Die elastische Schutzhülle 7 besteht entweder aus einem gasdichten Material oder zumindest aus einem Material, welches als Diffusionssperre gegenüber Gasen, insbesondere Wasser und Wasserdampf wirkt. Vorteilhafterweise wird der innere Hohlraum 9 der elastischen Schutzhülle 7, in dem sich der Aktor 4 befindet, evakuiert und/oder mit einem trockenen Schutzgas gefüllt. Dabei kann sich die Schutzhülle 7 bündig an den Aktor 4 anlegen oder von diesem beabstandet bleiben. Die Schutzhülle 7 kann sich sowohl innerhalb des Drehwandlers 1 befinden, wie dies Fig.10 zeigt, als diesen auch von Außen umschließen, wie in Fig.12 dargestellt. Insbesondere eignen sich als elastische Schutzhülle 7 alle Arten von organischen und anorganischen Beschichtungen sowie Materialverbindungen derselben. Beispiele hierfür sind Lacke, Kunststoffe, Gläser, Keramiken, Metalle, Metalllegierungen und Elastomere. Die Schutzhülle 7 kann auch aus einer glatten oder strukturierten dünnwandigen oder einer balgartigen Struktur bestehen, die der Längenänderung des Drehstellers 1 in z-Richtung nur einen geringen mechanische Widerstand entgegensetzt. Für die hermetische Abdichtung des Aktors 4 kann die Schutzhülle 7 den Drehwandler 1, wie in Fig.12 verdeutlicht, auch umschließen, wobei sie an dem Drehwandler 1 anliegen oder von diesem beabstandet sein kann. Zum Schutz kann der Drehwandler 1 beispielsweise von Außen mit einer Kunststoffmasse umspritzt oder mit einem schlauchartigen oder hülsenartigen Gebilde überzogen sein. Auch kann der Drehwandler 1 selbst eine hermetisch dichte Wandung besitzen.

Fig.11 zeigt den Drehwandler aus Fig.10 im zusammengebauten Zustand. Die Halter sind aus Gründen der Übersichtlichkeit in Fig.10, Fig.11 und Fig.12 nicht gezeigt. Zum Betrieb des Drehstellers werden an die Anschlüsse 4.1, 4.2 des Aktors 4 elektrische Spannungen angelegt. Hierdurch ändert der Aktor 4 seine Länge und übt auf die Kopfplatte 2.1 und die Fußplatte 2.2, vorzugsweise in Richtung der z-Achse als Symmetrieachse des Drehstellers, Kräfte aus. Aufgrund der Federwirkung von Drehwandler 1 und Balg 7 führen die vom Aktor 4 ausgeübten Kräfte zu einer Längenändernung sowohl des Aktors 4 als auch der mit ihm verbundenen Elemente Drehwandler 1 und Balg 7 entlang der z-Achse, wodurch sich der Äquatorbereich 1.3 gegenüber den endseitigen Bereichen 1.1. 1.2 verdreht. Ein Halter und eine Nutzlast können sowohl im Bereich der Kopfplatte 2.1, der Fußplatte 2.2 oder von Kopfplatte 2.1 und Fußplatte 2.2 sowie an dem Äquatorbereich 1.3 des Drehwandlers befestigt sein. Die Funktion von Halter und Nutzlast sind grundsätzlich vertauschbar.

Eine hermetische Abdichtung des mindestens einen Aktors 4 ist bei allen erfindungsgemäßen Ausführungen des Drehstellers bzw. Drehwandlers anwendbar.

Der Aktor 4 kann auch aus mehreren einzelnen Aktoren zusammengesetzt sein, wobei die einzelnen Aktoren separate elektrische Anschlüsse aufweisen oder diese elektrisch zu Gruppen oder zu einem einzigen Aktor elektrisch verschaltet sein können. Insbesondere erlaubt der erfindungsgemäße Drehsteller auch die Verwendung mehrerer Aktoren mit unterschiedlichen Wirkprinzipien zur Anregung des Drehwandlers. Hierzu können beispielsweise elektromagnetische mit piezoelektrischen Aktoren zur Betätigung des Drehwandlers zusammenwirken. Insbesondere kann der Drehwandler auch als mikroelektromechanisches System (MEMS), als mikrosystemtechnisches oder mikromechanisches Bauteil ausgeführt sein. Zur Anregung des Drehwandlers eignen sich ebenfalls elektrostatische, elektrothermische, dielektrische (Polymeraktoren) sowie elektropneumatische, magnetic shape memory (MSM) und magnetostriktive Aktorprinzipien und Aktoren sowie alle Arten physikalischer und/oder chemischer Aktoren. Die Funktion des Drehwandlers ist somit auf kein bestimmtes Aktorprinzip beschränkt.

Bei dem in Fig.12 gezeigten Ausführungsbeispiel eines Drehstellers, ist der Drehwandler von einer elastischen hermetisch dichten Hülle 7 umgeben. Insbesondere kann die außerhalb des Drehwandlers 1 angebrachte hermetisch dichte Hülle 7 aus einem dünnwandigen Rohr oder einem schlauchartigen Gebilde unterschiedlichster Materialien, beispielsweise einer beschichteten oder unbeschichteten Kunststofffolie bestehen. Zur Erhöhung der Diffusionsdichtheit eignet sich inbesondere die Beschichtung der elastischen Hülle mit Metallen oder Metalllegierungen. Eine hermetisch abdichtende Hülle 7 kann auch durch Umspritzung des Drehwandlers 1 mit einem Kunststoff oder Compound hergestellt werden.

Zur Verstärkung der Drehbewegung kann der Drehsteller mehrere Drehwandler aufweisen, die von einem gemeinsamen oder mehreren Aktoren angetrieben werden und die so zusammenwirken, dass sich die Drehbewegungen der einzelnen Drehwandler überlagern, also entweder addieren oder subtrahieren. Hierzu zeigen Fig.13 und Fig.14 ein Ausführungsbeispiel, bei dem ein Aktor 4 einen ersten Drehwandler 1, bestehend aus den Bereichen 1.1 bis 1.5 und einen zweiten Drehwandler 11, bestehend aus den Bereichen 11.1 bis 11.5 antreibt. Der Außendurchmesser des Drehwandlers 1 ist kleiner, als der Innendurchmesser des Drehwandlers 11, so dass der Drehwandler 1 in den Drehwandler 11 eingeschoben werden kann. Beide Drehwandler 1, 11 wirken auf eine gemeinsame Kopfplatte 2.1 und auf eine gemeinsame Fußplatte 2.2, mit denen sie mechanisch, ggf. unter einer mechanischen Vorspannung, verbunden sind. Das doppeltwirkende Prinzip des in den Fig.13, Fig.14 dargestellten Drehstellers beruht darauf, dass sich der Äquatorbereich 1.3 des Drehwandlers 1 gegenüber dem Äquatorbereich 11.3 des Drehwandlers 11 bei gleichsinniger Längung oder Stauchung der beiden Drehwandler bezüglich der Kopf- und Fußplatte 2.1, 2.2 um die z-Achse entgegengesetzt drehen. Dieses Verhalten wird durch eine entgegengesetzte Orientierung der Armwinkel beider Drehwandler erreicht, so wie in Fig.13, Fig.14 veranschaulicht. Bilden die Arme 1.4 des Drehwandlers 1 auf dessen Umfang mit der z-Achse einen positiven Winkel, so bilden die Arme 11.4 des Drehwandlers 11 mit der z-Achse einen negativen Winkel. Gleiches gilt für die Winkelorientierung der Arme 1.5 des Drehwandlers 1 bezüglich der Winkelorientierung der Arme 11.5 des Drehwandlers 11. Bei gegebener Längenänderung des Aktors 4 folgt somit eine Drehung des Äquatorbereiches 1.3 des Drehwandlers 1 um +$\varphi$ und gleichzeitig eine entgegengesetzte Drehung des Äquatorbereichs 11.3 des Drehwandlers 11 um $\omega$, so dass sich die Äquatorbereiche 1.3 und 11.3 gegeneinander um den Winkel ($\varphi+\omega$) verdrehen. Weisen beiden Drehwandler identische Eigenschaften auf, so verdoppelt sich die Winkeldrehung im Vergleich zu einem einzelnen Drehwandler, auf 2·$\varphi$. Zur mechanischen Kontaktierung z.B. einer Nutzlast 6 oder eines Halters an den Äquatorbereich 1.3 des Drehwandlers 1, weist der Äquatorbereich 11.3 des Drehwandlers 11 die mindestens eine Ausnehmung 12 auf, wie Fig.14 zeigt, durch die hindurch das Verbindungselement 5 mit dem Äquatorbereich 1.3 verbunden werden kann. Verbindungselement 5 und Ausnehmung 12 sind so dimensioniert, dass innerhalb des gewünschten Drehwinkelbereiches eine Berührung des Verbindungselementes 5 mit dem Drehwandler 11 vermieden wird. Mit dem Verbindungselement 5 wird entweder eine Nutzlast verbunden, oder dieses ist ortsfest, z.B. mit einem nicht dargestellten Gehäuse, verbunden. Analog ist der Halter 3 mit mindestens einem der Verbindungselemente 3.1, 3.2 mit dem Äquatorbereich 11.3 des Drehwandlers 11 verbunden. Der Halter 3 kann ebenfalls eine Nutzlast darstellen oder eine solche mit diesem verbunden sein. Die verstärkte Drehbewegung ist eine Relativdrehung der Äquatorbereiche 1.3 und 11.3 gegeneinander bzw. der mit den Äquatorbereichen 1.3 und 11.3 verbundenen Verbindungselemente 5 und 3.1, 3.2. Welches der Verbindungselemente mit einem ortsfesten Gehäuse verbunden ist und an welchem die Nutzlast angebracht wird, ist ausschliesslich eine Frage des Bezugssystems und für die Funktion des Drehstellers unerheblich.

Zur weiteren Veranschaulichung von Aufbau und Wirkungsweise zeigen Fig.15 eine seitliche Ansicht, Fig.16 eine Schnittdarstellung und Fig.17 eine perspektivische Ansicht des doppelt wirkenden Drehstellers. Insbesondere gehen aus Fig.15 und Fig.17 die gegeneinander verschränkten Armstrukturen 1.4 zu 11.4 und 1.5 zu 11.5 der beiden Drehwandler 1, 11 und der ineinander geschachtelte Aufbau der beiden Drehwandler 1, 11 hervor. Desweiteren ist aus den Fig.16 und Fig.17 die gemeinsame Befestigung der beiden Drehwandler 1, 11 an Kopfplatte 2.1 und Fußplatte 2.2 sowie die Anordnung des Aktors 4 ersichtlich.

Fig.18 zeigt ein weiteres Ausführungsbeispiel des erfindungsgemäßen Drehstellers, mit einem außerhalb des Drehwandlers 1 angeordneten Aktor 4, wobei Fig.18 a.) eine Seitenansicht und Fig.18 b.) eine perspektivische Ansicht zeigt. Der Aktor 4 und der Drehwandler 1 sind parallel zu einer z-Achse orientiert und an ihrem jeweils einen Ende auf der Grundplatte 3 befestigt. Senkrecht zur Grundplatte 3 befindet sich ein Träger 15, der an seinem der Grundplatte 3 abgewandten Ende ein Gelenk 13 aufweist. Das Gelenk 13 ist vorteilhafterweise als Festkörpergelenk ausgebildet, kann jedoch auch ein klassisches Drehlager, z.B. ein Kugellager, sein. Das Drehgelenk 13 ist mit einem Hebel 16 verbunden. Der Hebel 16 ist mit seinem einen Ende, mit dem der Grundplatte 3 abgewandten Ende 1.1 des Drehwandlers 1 verbunden. Hierzu kann der Drehwandler 1 direkt mit dem Hebel 16 verbunden werden oder der Drehwandler 1 kann an seinem hebelseitigen Ende eine Kopfplatte aufweisen, die über einen Stößel mit dem Hebel 16 verbunden ist. Das andere Ende des Hebels 16 ist mit dem der Grundplatte 3 abgewandten Ende des Aktors 4 verbunden. Zur Krafteinleitung des Aktors 4 in den Hebel 16 kann auch dieser einen Stößel 14 aufweisen. Der Aktor 4 erzeugt bei Anlegen elektrischer Spannungen an die Anschlussstifte 4.1, 4.2 vorwiegend in Richtung der z-Achse wirkende Kräfte bzw. Auslenkungen, die über den Stößel 14 in den Hebel 16 eingeleitet werden.

Die vom Aktor 4 erzeugten Kräfte werden mit dem Hebelverhältnis $y1/y2$ und die Auslenkungen mit dem reziproken Hebelverhältnis $y2/y1$ in den Drehwandler 1 eingeleitet, wobei $y1$ den Abstand des Drehgelenkes 13 zum Krafteinleitungspunkt des Aktors 4 und $y2$ den Abstand des Drehgelenkes 13 zum Krafteinleitungspunkt in den Drehwandler 1 bezeichnen. Sofern $y2 > y1$ ist, werden die Auslenkungen des Aktors 4 mit dem Hebelverhältnis $y2/y1$ verstärkt in den Drehwandler eingeleitet. Durch Wahl eines geeigneten Hebelübersetzungsverhältnisses kann die Kraft/Wegcharakteristik des Aktors 4 an die mechanischen Eigenschaften des Drehwandlers 1 angepasst werden. Insbesondere können geringe Auslenkungen des Aktors 4 bei hoher Kraft, z.B. eines piezoelektrischen Aktors, durch den Hebel auf einfache Weise in größere Auslenkungen bei geringerer Kraft umgesetzt und auf diese Weise große Drehbewegungen eines mit dem Drehwandler 1 verbundenen Elementes 6, z.B. eines Spiegels, erzeugt werden. Das Hebelübersetzungsverhältnis kann jedoch auch $\leq 1$ betragen. Durch die räumliche Trennung von Drehwandler 1 und Aktor 4 wird eine zusätzliche Variabilität bezüglich der Art, der Ausführung und der Bauform von Drehwandler 1 und Aktor 4 erzielt.

Fig.19 zeigt das Ausführungsbeispiel eines nicht erfindungsgemäßen Drehwandlers mit nur einer Armstruktur 1.4, die den oberen ringförmigen Bereich 1.1 mit dem unteren ringförmigen Bereich 1.2 verbindet, wobei die Arme 1.4 durch gegenüber der auf den Umfang des Drehwandlers projizierten z-Achse geneigt sind. Fig.19 a.) stellt eine Aufsicht, Fig.19 b.) einen Schnitt und Fig.19 c.) eine perspektivische Ansicht des so erhaltenen Drehwandlers dar. Eine axiale Längenänderung des Aktors 4 durch Anlegen elektrischer Signalspannungen an die Anschlüsse 4.1, 4.2 des Aktors 4 führt zu einer der Längenänderung proportionalen Verdrehung der ringförmigen Bereiche 1.1, 1.2 gegeneinander und um die z-Achse. Der Aktor 4 überträgt die von ihm erzeugten Kräfte bzw. Auslenkungen über ein aus den Elementen 17 und 18 gebildetes Drehlager auf die Kopfplatte 2.1. Das Element 17 weist die Funktion einer Lagerschale auf, welche eine Kugel 18 zentral aufnehmen kann, um die vom Aktor 4 erzeugten Kräfte/Auslenkungen auf die Kopfplatte 2.1 als zweite Lagerschale zu übertragen. Hierdurch wird eine widerstandsarme Drehung der Kopfplatte 2.1 und des mit dieser verbundenen ringförmigen Bereichs 1.1 des Drehwandlers 1 gegenüber der Fußplatte 2.2 und dem mit dieser verbundenen ringförmigen Bereichs 1.2 ermöglicht. Bei Fixierung der Fußplatte 2.2 mit einem als ortsfest angenommenen Halter 3 dreht sich bei Ansteuerung des Aktors 4 die Kopfplatte 2.1 und die mit dieser über ein Verbindungselement 5 verbundene Nutzlast, z.B. ein Spiegel, um die z-Achse. Die zwischen Aktor 4 und Kopfplatte 2.1 eingefügte Drehlagerung 17, 18 ist insbesondere bei Festkörperaktoren vorteilhaft und kann bei Aktoren, die über Feldwirkungen Kräfte auf die Fußplatte 2.1 und die Kopfplatte 2.2 übertragen, entfallen. Beispiele für solche Aktoren sind Elektromagnete, elektrostatische Aktoren oder hydraulische oder pneumatische Aktoren. Fig.20 a.) und Fig.20 b.) zeigen eine Variante des nicht erfindungsgemäßen Drehstellers mit einfacher Armstruktur und Hebelübersetzung, bei dem sich der Aktor 4 außerhalb des Drehwandlers 1 befindet. Die Übertragung der vom Aktor 4 erzeugten Kräfte auf den Drehwandler 1 erfolgt durch den mittels des Drehlagers 13 gelagerten Hebel 16. Der Aktor 4 leitet die Kräfte/Auslenkungen über den Stößel 14 in den Hebel 16 ein, der diese mit dem Hebelverhältnis y2/y1 übersetzt durch die Kugel 18 auf den Drehwandler 1 überträgt. Das Hebelverhältnis y2/y1 ermöglicht eine Anpassung der Weg/Kraftcharakteristik des Aktors 4 an den Drehwandler 1. Die Drehlagerung durch die Kugel 18 gestattet Drehungen des Bereiches 1.1 und der mit diesem verbundenen Elemente Verbindungsstück 5 und Nutzlast 6 um die z-Achse.

Zur Vergrößerung des Drehwinkelbereiches um eine Achse können mehrere Drehwandler zusammengefügt werden.

Die bisherigen Ausführungsbeispiele dienten insbesondere der elektrisch gesteuerten Erzeugung von Drehbewegungen um eine Achse. Drehbewegungen um mehrere Achsen können leicht durch Kombination mehrerer Drehsteller erzeugt werden. Hierzu erzeugt beispielsweise ein erster Drehsteller Drehbewegungen um eine erste Achse. Zur Erzeugung von Drehbewegungen um eine zweite, zur ersten nicht parallel verlaufende Achse, wird ein zweiter Drehsteller so als Nutzlast an dem ersten Drehsteller befestigt, dass dessen Drehachse nicht parallel zur Drehachse des ersten Drehstellers verläuft. Besonders vorteilhaft ist es, wenn die einzelnen Drehachsen der Drehsteller zueinander orthogonal sind. Auf die gleiche Art können weitere Drehsteller angebracht werden, um Drehungen um weitere Raumachsen zu ermöglichen.

Drehbewegungen um mehrere Achsen können auch auf die in den Ausführungsbeispielen gemäß Fig.21 a.) und Fig.21 b.) gezeigte Art und Weise erzeugt werden. Der in Fig.21 dargestellte zweiachsige Drehsteller kann sowohl Drehungen einer Nutzlast 6 um eine erste z-Achse, als auch Drehungen der Nutzlast 6 um eine zweite y-Achse erzeugen. Der zweiachsige Drehsteller besteht aus zwei Drehstellern 1, 1' der erfindungsgemäßen Art, die axial hintereinander in einem gemeinsamen Halter 3 angeordnet sind und als gemeinsame Symmetrieachse die z-Achse aufweisen. Jeder der beiden Drehsteller 1, 1' ist einzeln über die elektrischen Anschlüsse 4.1, 4.2 bzw. 4.1', 4.2' elektrisch ansteuerbar. Der Halter 3 ist mit seinen Endflanschen 3.1, 3.1' so dimensioniert, dass er den axialen Bewegungen der Aktoren 4, 4' einen nur geringen mechanischen Widerstand entgegensetzt. Die Aktoren 4, 4' stützen sich an einem gemeinsamen Mittelbereich 3.12 des Halters 3 ab. Jeder der Drehsteller ist in der Lage, Drehbewegungen seines Äquatorbereiches 1.3, 1.3' zu erzeugen. Die Nutzlast 6 ist über biegeweiche Verbindungselemente 14, 14', z.B. Stifte und die mechanischen Verbindungsstücke 5, 5' mit den Äquatorbereichen 1.3, 1.3' verbunden. Die Verbindungsstücke 5, 5' sind mechanisch steif, so dass die Drehbewegungen der Äquatorbereiche 1.3, 1.3' über die Stifte 14, 14' in die Nutzlast 6 eingeleitet werden. Der Bereich 3.12 des Halters 3 und die Verbindungsstücke 5, 5' sind voneinander beabstandet und berühren sich nicht.

Zur Erzeugung von Drehbewegungen $\Omega$ der Nutzlast 6 um die senkrecht zur z-Symmetrieachse verlaufende y-Achse, werden beide Aktoren 4, 4' gleichsinnig angesteuert, d.h. beide Aktoren verkürzen sich oder beide Aktoren elongieren. Aufgrund der in Fig.21 nur beispielhaft gewählten Antisymmetrie der beiden Drehwandlerstrukturen führt dies zu gegensinnigen Drehbewegungen $+\varphi$, $-\omega$ oder $-\varphi$, $+\omega$ der Äquatorbereiche 1.3, 1.3' um die z-Achse, die durch die Stifte 14, 14' auf die Nutzlast 6 übertragen werden und diese um die y-Achse um einen Winkelbetrag drehen. Werden die beiden Aktoren 4, 4' gegensinnig elektrisch angesteuert, so hat dieses eine gleichsinnige Drehung $+\varphi$, $+\omega$ oder $-\varphi$, $-\omega$ der Äquatorbreiche 1.3, 1.3' zur Folge. Dies führt zu einer Drehung $\Psi$ der Nutzlast 6 um die z-Achse. Die vorgestellte Anordnung kann elektrisch kontrolliert steuerbare Drehbewegungen einer Nutzlast um zwei Raumachsen $\Omega$, $\Psi$ ausführen.

Ebenso ist es bei dem in Fig.21 abgebildeten Ausführungsbeispiel eines zweiachsigen Drehsteller möglich, die Aktoren außerhalb der Drehwandler anzuordnen, wie das Ausführungsbeispiel Fig.22 a.) und Fig.22 b.) verdeutlicht. Die von den Aktoren 4, 4' generierten Auslenkungen werden über drehgelagerte Hebel 16, 16' wie bereits in Fig.18 beschrieben, hubüber- oder hubuntersetzt in die Drehwandler 1, 1' eingeleitet. Als Drehlager 13, 13' finden bevorzugt Festkörpergelenke Anwendung. Die Aktoren 4, 4' können durch mechanische Federn druckvorgespannt und mit Hilfe einer Umhüllung hermetisch gegenüber Umwelteinflüssen geschützt sein. In den Figuren Fig.18 und Fig.22 ist das mechanische Vorspannmittel durch rohrförmige Federn 4, 4' veranschaulicht. Auf eine weitere Erläuterung der Funktion wird verzichtet, da diese analog zu dem Auführungsbeipiel in Fig.21 ist.

Als erfindungsgemäße Drehwandler können auch stabförmige Strukturen dienen. Hierfür eignen sich sowohl gerade stabförmige Strukturen beliebigen Querschnitts, welche die ringförmigen Bereiche 1.1, 1.2, 1.3 ... 1.x miteinander verbinden, als auch räumlich gekrümmte stabförmige Strukturen. Insbesondere sind für den Drehwandler auch Strukturen geeignet, die aus der Verdrehung einer beliebig geformten Grundfläche, die auch ein Hohlprofil sein kann, längs einer Erstreckungsachse und um diese Achse hervorgehen, so dass unter der Einwirkung von Zug- und/oder Druckkräften auf die stabförmige Struktur, deren Querschnittsbereiche längs der Erstreckungsachse ihre Winkellage verändern. Derartige Strukturen können beispielsweise durch Strangpressen und/ oder Verdrillung hergestellt werden. Zur Erzeugung der Betätigungskräfte auf die Drehwandler dienen vorzugsweise elektrisch betätigbare Aktoren.

Die Form des Drehwandlers ist daher nicht auf zylindrische, hohlzylindrische oder konische Formen der vorgestellten Art beschränkt, sondern dieser kann aus beliebigen Profilformen, insbesondere aus kasten-, kreis- oder sternförmigen Hohl- oder Vollprofilen bestehen, die längs einer Achse um einen Winkel verdrillt sind. Beispiele für derartige Ausführungsformen des Drehwandlers sind in Fig.23 dargestellt, wobei das jeweils linke Bild nur das Wandprofil des Drehwandlers und das rechte Bild jeweils das Drehwandlerwandprofil mit scheibenförmigen Endbereichen zeigt. Fig.23 a.) zeigt ein kastenförmiges Hohlprofil, Fig.23 b.) ein elliptisches Hohlprofil und Fig.23 b.) ein sternförmiges Vollprofil, welches jeweils längs einer z-Achse verdrillt wurde. Die dargestellten Profile haben die Eigenschaft von Stabfedern, die bei Einwirkung von Zug- und/oder Druckkräften ihre Länge ändern, wobei sich die senkrecht zur z-Achse liegenden Querschnitte der Stabstruktur zueinander verdrehen. Vereinfacht ausgedrückt werden die verdrillten Stabstrukturen durch Zugkräfte gerade gezogen, wobei der Verdrillungswinkel abnimmt. Umgekehrt bewirken Druckkräfte eine Stauchung, wobei der Verdrillungswinkel zunimmt. Durch Befestigung einer Halterung und einer Nutzlast in einem Abstand längs der z-Achse wird eine Drehung der Nutzlast in Bezug auf die Halterung erzeugt, womit die Stabstrukturen die Funktion der beschriebenen Drehwandler erfüllen. Anstelle hohlzylindrischer Drehmomentwandlerstrukturen wie u.a. in Fig.8 gezeigt, können somit auch solche aus verdrillten Stäben, Hohlprofilen oder sonstigen Querschnitten auf die beschriebene Art erzeugte Strukturen als Drehwandler eingesetzt werden.

Die stabfederartigen Drehwandler können, analog zu den bisher beschriebenen Drehwandlern mit einer bezüglich einer mittleren Äquatorebene 1.3 antisymmetrischen Verdrillung ausgeführt werden. Die Fig. 24 a.)zeigt ein entsprechendes Ausführungsbeispiel für ein kastenförmiges Hohlprofil, die Fig.24 b.) für ein elliptisches Hohlprofil und die Fig.24 c.) für ein sternförmiges Vollprofil. Die mittlere Symmetrieebene entspricht dabei dem Äquatorbereich 1.3 der hohlzylindrischen Drehwandler z.B. aus Fig.1, d.h. der Äquatorbereich 1.3 verdreht sich bei Längung und/oder Stauchung der Stabfeder längs der z-Achse gegenüber deren endseitigen Bereichen 1.1, 1.2. Die Wandstrukturen 1.4 und 1.5 sind bezüglich der Äquatorebene antisymmetrisch, bei den in Fig.24 gezeigten Ausführungsformen insbesondere spiegelsymmetrisch. Durch Kombination von Stabfedersegmenten 1.4, 1.5 ... 1.x mit unterschiedlichem Verdrillungswinkeln, unterschiedlichem Drehsinn, unterschiedlichen Längen und unterschiedlichen Profilen kann eine Vielfalt von Drehwandlerstrukturen dargestellt werden. Insbesondere kann sich auch der Querschnitt der Stabfedern längs der z-Achse ändern, z.B. erweitern oder verjüngen und/oder von einem Querschnitt in einen anderen übergehen.

Die Verbindung der drehenden und der feststehenden Bereiche eines Drehwandlers kann sowohl über gerade als auch räumlich gekrümmte Strukturen erfolgen. Für letztere zeigt Fig.25 a.) ein nicht erfindungsgemäßes Beispiel, bei dem die Wandung des Drehwandlers aus spiralförmig gebogenen streifenartigen Armen 1.4 besteht, die um eine z-Achse rotationssymmetrisch angeordnet sind. Fig.25 b.) zeigt diesen nicht erfindungsgemäßen Drehwandler mit endseitig befestigten Scheiben 1.1 und 1.2, über die durch einen nicht dargestellten Aktor vorzugsweise axiale in z-Richtung wirkende Kräfte eingeleitet werden können, wodurch sich die Bereiche 1.1 und 1.2 gegeneinander verdrehen.

Durch Kombination zweier Drehwandlerstrukturen mit entgegengesetztem Windungssinn der in Fig.25 a.), Fig.25 b.) gezeigten Art, gelangt man zu dem in Fig.26 gezeigten Ausführungsbeispiel, bei dem sich bei axialer Kraftbeaufschlagung der mittlere Äquatorbereich 1.3 gegenüber den endseitigen Bereichen 1.1, 1.2 verdreht.

Mittels elektronischer Maßnahmen kann die Drehwinkelcharakteristik der vorgestellten Drehsteller in gewünschter Weise beeinflusst, insbesondere linearisiert werden. Auch kann auf diese Weise das Temperaturverhalten optimiert und eine temperaturunabhängige Funktion über einen Temperaturbereich hinweg sichergestellt werden. Insbesondere kann durch derartige elektronische Korrekturmaßnahmen bei mehrachsigen Drehstelleren eine Entkopplung der Drehachsen erfolgen. Mittels elektronischer Signalauswerteeinheiten, die z.B. Strom, Spannung und Ladung erfassen, können Rückwirkungen detektiert und das dynamische und statische Verhalten verbessert werden. Beispielsweise kann hierdurch ein Überschwingen minimiert bzw. verhindert und/oder ein Kontakt der Nutzlast mit einem Objekt detektiert werden. Die Detektion von Kraftrückwirkungen auf die Nutzlast, ist speziell im Bereich der Medizintechnik und der Robotik von hoher Bedeutung. Insbesondere kann der erfindungsgemäße Drehsteller in einem geschlossenen Regelkreis betrieben werden, beispielsweise zur statischen und/oder dynamischen Nachführung von Objekten. Bevorzugterweise ist das von dem Drehsteller verstellbare Objekt Teil des Regelkreises, beispielsweise ein Spiegel, der optische Signale auf ein Empfangsgerät, z.B. eine CCD-Kamera oder Fotosensoren überträgt, so dass Sollabweichungen erfasst und ausgeregelt werden können.

Die elektrische Signalerfassung und Auswertung ermöglicht ferner eine Selbstüberwachung der ordnungsgemäßen Funktion und erhöht die Betriebssicherheit und Betriebsstabilität.

Neben Ablenk- und Projektionssystemen aller Art eignen sich die erfindungsgemäßen Drehsteller insbesondere für die Manipulation von Objekten, wobei die beschriebene elektronische Signalauswertung zusätzlich die Erfassung von Kraftrückmeldungen in Echtzeit ermöglicht(Realtime Force Feedback). Derartige Anwendungen finden sich in vielen technischen und industriellen Bereichen, u.a in der Produktions- und Automatisierungtechnik beim Assemblieren und Fügen von Gegenständen, in der Medizintechnik speziell der Operationsrobotik, der Luftfahrttechnik zur Erfassung aerodynamischer Kräfte oder der Automobil-und Gebäudetechnik als Einklemmschutz.

Aufgrund der Fähigkeit der erfindungsgemäßen Drehsteller, auch massebehaftete Nutzlasten mit hoher Genauigkeit und Dynamik Drehen und Schwenken zu können, ergibt sich eine besondere Eignung im Bereich von Fahrerinformationssystemen (HUD - Head Up Display). Ein HUD ist ein optisches System, welches Informationen z.B. über Geschwindigkeit oder zur Navigation in das Sichtfeld des Fahrers eines Kraftfahrzeuges einspiegelt. Ein HUD kann die Komponenten Lichtquelle, Lichtmodulator (TFT, LCD, DLP, Mikroablenkspiegel), optische Elemente wie Linsen, Spiegel, Elektronik und Elektromechanik zur Verstellung aufweisen. Am Markt sind Systeme, bei denen die optischen Informationen direkt in die Windschutzscheibe eingespiegelt werden und solche, bei denen die optischen Informationen auf eine als Combiner bezeichnete optisch teildurchlässige Scheibe, die mittels einer elektromechanisch betätigten Kinematik in das Sichtfeld des Fahrers positioniert wird, eingespiegelt werden. Die Kinematik besteht bei heutigen Systemen vielfach aus Elektromotoren oftmals gekoppelt mit Getrieben, aus Kurvenscheiben, Zahnstangen, Zahnrädern, Führungsschienen und ähnlichen mechanischen Komponenten und einer Motorsteuerungselektronik. Vielfach wird der als Combiner bezeichnete Hauptspiegel in einer Führungsschiene oder Kulisse geführt und von den elektromechanischen Komponenten entlang der Führungsschiene in das Sichtfeld des Fahrers ausgefahren oder im Ruhezustand in das HUD eingefahren. Entsprechend der unterschiedlichen Fahrergrößen, ist es wünschenswert, dass der Combiner unterschiedliche Positionen einnehmen kann. Die hierzu erforderliche aus zahlreichen Komponenten bestehende Elektromechanik ist störanfällig, kostenintensiv, benötigt einen großen Bauraum, verursacht Arbeitsgeräusche und gestattet keine hinreichend dynamische Verstellung.

Neben der quasistatischen Verstellung zielen neuere Verfahren auf die dynamische und/oder adaptive Verstellung des Combiners und/oder anderer optischen Komponenten eines Fahrerinformationssystemes ab, um so auch bei Veränderungen der Augenpositionen des Fahrers eine verzerrungsfreie, lichtstarke und korrekte Darstellung der optischen Informationen zu gewährleisten. Beispielsweise kann durch Verfolgung der Augenpositionen des Fahrers mittels Eye-Tracking, ein Regelkreis aufgebaut werden, mit dessen Hilfe die optischen Komponenten geeignet nachgeführt werden können. Heutige HUD-Systeme verfügen nicht über die hierzu notwendige Dynamik und Genauigkeit.

Projektionssysteme (Beamer, Rückprojektoren, Displays etc.) und sogenannte DLP Devices (digital light processing), die zu diesem Zwecke geeignet sein könnten, weisen signifikante Einschränkungen auf. DLPs basieren auf mikroelektromechanischen Systemen (MEMS) und bestehen aus einem Array elektrisch, i.a. elektrostatisch, individuell aktuierbarer Mikrospiegel, sogenannten DMDs (Digital Micromirror Devices). Texas Instruments bietet DLP Devices für verschiedenste Anwendungen an. Bei diesen wird das Licht einer Lichtquelle von Mikrospiegeln der DMDs in diskrete Raumrichtungen reflektiert. Die Mikrospiegel der DMDs können mit hoher Frequenz zwischen zwei diskreten Positionen, beispielsweise zwischen +12° und -12°, geschaltet werden. Eine analoge Verstellung der Spiegel eines elektrostatisch geschalteten DMDs ist nach dem derzeitigen Stand der Technik nicht bekannt. Wird in einer Neutralposition zur Darstellung der optischen Informationen nur ein Teil der aktiven Spiegelfläche eines DMD benutzt, kann das projizierte Bild prinzipiell innerhalb der in der Neutralposition nicht benutzten Fläche des DMD verschoben werden. Mithilfe der abbildenden Optik eines HUD können auf diese Weise Änderungen der Betrachtungsposition, z.B. eines Kfz-Fahrers, in Grenzen korrigiert werden. Da hierbei andere Bereiche des Combiners und der sonstigen optischen Komponenten des HUD, wie Nebenspiegel, Linsen etc. ausgeleuchtet werden, müssen dies entsprechend überdimensioniert werden. Eine Vergrößerung der optischen Elemente, ist aus Bauraum- und Kostengründen jedoch unerwünscht.

Erfindungsgemäß wird diese Aufgabe, wie in Fig.27 dargestellt, durch einen am Combiner befestigten und mit diesem mitfahrenden und gesteuert betreibbaren Elektromotor gelöst, wobei zur dynamischen Verstellung optischer Komponenten der erfindungsgemäße Drehsteller verwendet werden kann. Bevorzugterweise werden die optischen Komponenten, insbesondere der Combiner 20, mittels eines an dem Combiner 20 befestigten elektrisch steuerbaren mitfahrenden Elektromotors 21 direkt in einer Führungsschiene 22 bewegt und positioniert. Der mitfahrende Elektromotor 21 weist hierzu die mindestens eine Achse 23.1 mit einem Zahnrad 24.1 auf, welches im Eingriff mit einer Verzahnung 25.1 der Führungsschiene 22.1 ist. Vorteilhafterweise weist der mitfahrende Elektromotor 21 zwei Achsen 23.1, 23.2 bzw. eine durchgehende Achse mit zwei Zahnrädern 24.1, 24.2 und zwei verzahnten Führungsschienen 22.1 mit 25.1 und 22.2 mit 25.2 auf, so dass jedes der Zahnräder mit einer Führungsschiene im Eingriff ist. Zur Gewährleistung des Eingriffs der Motorwellen 23.1, 23.2 in die Verzahnungen 25.1, 25.2 der Führungsschienen 22.1, 22.2 können die Motorwellen jeweils einen zapfenförmigen Überstand 27.1, 27.2 aufweisen, mit dem sie in Nuten 26.1, 26.2 der Führungsschienen gleiten.

Mit der Motoransteuerungselektronik kann der mitfahrende Elektromotor 21 z.B. über ein flexibles Kabel 25, z.B. ein Kaptonkabel, verbunden sein oder die Führungsschienen 22.1, 22.2 weisen elektrische Kontaktbahnen auf, von denen die elektrischen Signale für den Motor über Kontaktschleifer abgenommen werden können. Die erfindungsgemäße Idee ermöglicht einen äusserst kompakten, zuverlässigen, kostengünstigen und geräuscharmen Antrieb des Combiners und/oder anderer Komponenten eines Fahrerinformationssystemes, wobei zur Verstellung der optischen Komponenten, insbesondere des Combiners, der Combiner durch den mitfahrenden Antriebsmotor quasistationär und durch den, in Fig.27 nicht dargestellten, erfindungsgemäßen Drehsteller dynamisch verstellt wird.

Werden die optischen Fahrerinformationen beispielsweise mittels eines DLP-, LED- oder LCD-Projektionssystemes erzeugt, kann der erfindungsgemäße Drehsteller zur statischen und/oder dynamischen Ausrichtung der optischen Elemente dienen, ohne dass diese vergrössert werden müssen.

Der erfindungsgemäße Drehsteller ermöglicht eine Miniaturisierung, neue Funktionalitäten und eine geringere Systemkomplexität derartiger Systeme. Vorteilhafterweise ist ein Drehsteller mit einem piezoelektrischen Aktor auch energieeffizient, da er nur im dynamischen Betrieb elektrische Leistung aufnimmt und Positionen leistungslos halten kann.

Durch die hohe Genauigkeit, die hohe Dynamik und den kompakten Aufbau eignet sich der erfindungsgemäße

**EP 2 759 052 B1**

Drehsteller insbesondere zur präzisen und dynamischen Bewegung trägheitsbehafteter Objekte.

**Patentansprüche**

1. Drehsteller aufweisend, beabstandete Segmente (1.1, 1.2, 1.3), die mittels mindestens einer Trägerstruktur verbunden sind, und mindestens einen Aktor (4) zur Ausübung von Kräften, wobei die Trägerstruktur im Wesentlichen eine Rotationssymmetrie um eine Achse (z) aufweist, aus Elementen (1.4, 1.5) besteht, die nicht parallel zur Achse (z) orientiert oder bezüglich der Achse (z) um einen Winkel $\alpha$ verdrillt und durch Drehung um die Achse (z) ineinander überführbar sind, wobei der Aktor (4) auf die Segmente (1.1, 1.2, 1.3) und die Trägerstruktur in Richtung der Achse (z) Kräfte auszuüben vermag, und wobei mindestens zwei im Wesentlichen zueinander koaxial angeordnete Trägerstrukturen vorgesehen sind, wobei mindestens ein Segment (1.3) einer Trägerstruktur mit mindestens einem Segment (1.3) einer anderen Trägerstruktur verbunden ist.

2. Drehsteller nach dem vorhergehenden Anspruch, mit einer Trägerstruktur, die den Aktor (4) umschließt oder mit einer Trägerstruktur, die außerhalb des Aktors (4) angeordnet ist.

3. Drehsteller nach einem der vorhergehenden Ansprüche, mit mehreren ineinander geschachtelten und/oder längs der Achse (z) hintereinander angeordneten Trägerstrukturen.

4. Drehsteller nach dem vorhergehenden Anspruch, wobei die Elemente (1.4) der einen Trägerstruktur und die Elemente (1.5) der anderen Trägerstruktur spiegelsymmetrisch zu einer Lotebene der Achse durch die verbundenen Segmente (1.3) sind.

5. Drehsteller nach einem der vorhergehenden Ansprüche, wobei mindestens eines der Segmente (1.1, 1.2) mit einem festen Objekt und mindestens ein anderes Segment (1.3) mit einem beweglichen Objekt verbunden sind.

6. Drehsteller nach einem der vorhergehenden Ansprüche,
wobei der mindestens eine Aktor (4) ein elektrisch steuerbarer Aktor, insbesondere ein Festkörperaktor oder ein piezoelektrischer Aktor oder ein magnetostriktiver Aktor oder ein elektromagnetischer Aktor oder ein elektrostatischer Aktor oder ein dielektrischer Elastomeraktor ist.

7. Drehsteller nach einem der vorhergehenden Ansprüche, mit einer hermetisch dichten Umhüllung des mindestens einen Aktors (4) und/oder mit einer hermetisch dichten Trägerstruktur.

8. Drehsteller nach einem der vorhergehenden Ansprüche, mit einer längs der Achse (z) eine Federrate aufweisenden Trägerstruktur.

9. Drehsteller nach dem vorhergehenden Anspruch, mit einer Trägerstruktur die den Aktor (4) mechanisch vorspannt.

10. Drehsteller nach einem der vorhergehenden Ansprüche, wobei die elektrischen Aktoren (4) einzeln ansteuerbar sind.

11. Verfahren zum Betrieb eines Drehstellers nach einem der vorhergehenden Ansprüchen, wobei durch elektrische Ansteuerung des mindestens einen Aktors (4) Segmente (1.1, 1.2, 1.3) und/oder mit den Segmenten verbundene Objekte zueinander Drehbewegungen ausführen, die der Ansteueramplitude und/oder der Polarität der Ansteuersignale proportional sind.

12. Verfahren zum Betrieb eines Drehstellers nach einem der vorhergehenden Ansprüche, wobei der Drehsteller in einem
geschlossenen Regelkreis betrieben wird und/oder Teil des
Regelkreises ist.

13. Verwendung eines Drehstellers nach einem der vorhergehenden Ansprüche zur Verstellung von Komponenten bei Fahrerinformationssystemen, insbesondere zur Verstellung von optischen Komponenten.

**Claims**

1. Rotary actuator having segments (1.1, 1.2, 1.3), which are spaced apart and are connected by means of at least one support structure, and at least one actuator (4) for exerting forces, wherein the support structure is substantially rotationally symmetrical about an axis (z) and is composed of elements (1.4, 1.5) which are not oriented parallel to the axis (z) or which are twisted through an angle α in relation to the axis (z) and can be converted into each other by rotating about the axis (z), wherein the actuator (4) is able to exert forces on the segments (1.1, 1.2, 1.3) and the support structure in the direction of the axis (z), and wherein at least two supports structures are provided and arranged substantially coaxially with each other, wherein at least one segment (1.3) of a support structure is connected to at least one segment (1.3) of another support structure.

2. Rotary actuator according to the preceding claim, with a support structure that encloses the actuator (4), or with a support structure that is arranged externally to the actuator (4).

3. Rotary actuator according to either one of the preceding claims, with a plurality of support structures that are nested inside each other and/or are arranged one behind the other along the axis (z).

4. Rotary actuator according to the preceding claim, wherein the elements (1.4) of the one support structure and the elements (1.5) of the other support structure have mirror symmetry relative to a vertical plane of the axis through the segments (1.3) which are connected.

5. Rotary actuator according to any one of the preceding claims, wherein at least one of the segments (1.1, 1.2) is connected to a stationary object and at least one other segment (1.3) is connected to a moving object.

6. Rotary actuator according to any one of the preceding claims, wherein the at least one actuator (4) is an electrically controllable actuator, particularly a solid-state actuator or a piezoelectric actuator or a magnetostrictive actuator or an electromagnetic actuator or an electrostatic actuator or a dielectric elastomer actuator.

7. Rotary actuator according to any one of the preceding claims, with a hermetically sealed cladding of the at least one actuator (4) and/or with a hermetically sealed support structure.

8. Rotary actuator according to any one of the preceding claims, with a support structure having a spring rate oriented along the axis (z).

9. Rotary actuator according to any one of the preceding claims, with a support structure which mechanically pre-loads the actuator (4).

10. Rotary actuator according to any one of the preceding claims, wherein the electrical actuators (4) can be activated individually.

11. Method for operating a rotary actuator according to any one of the preceding claims, wherein segments (1.1, 1.2, 1.3) and/or objects that are connected to the segments execute rotational movements towards each other in response to electrical activation by the at least one actuator (4), which movements are proportional to the actuation amplitude and/or the polarity of the activation signals.

12. Method for operating a rotary actuator according to any one of the preceding claims, wherein the rotary actuator is operated in a closed loop control circuit and/or is part of the closed loop control circuit.

13. Use of a rotary actuator according to any one of the preceding claims for shifting components in driver information systems in particular for shifting optical components.

**Revendications**

1. Actionneur rotatif comportant des segments espacés (1.1, 1.2, 1.3), qui sont reliés au moyen d'au moins une structure porteuse et d'au moins un actionneur (4) pour exercer des forces, dans lequel la structure porteuse présente essentiellement une symétrie de rotation autour d'un axe (z), se compose d'éléments (1.4, 1.5) qui ne sont pas orientés parallèlement à l'axe (z) ou sont tordus par rapport à l'axe (z) autour d'un angle α et peuvent passer de l'un en l'autre en tournant autour de l'axe (z), dans lequel l'actionneur (4) peut exercer une force sur les segments (1.1, 1.2, 1.3) et la structure porteuse dans le sens de l'axe (z), et dans lequel au moins deux structures porteuses disposés essentiellement coaxialement l'une par rapport à l'autre sont prévues, dans lequel au moins un segment (1.3) d'une structure porteuse est relié à au moins un segment (1.3) d'une autre structure porteuse.

2.  Actionneur rotatif selon la revendication précédente, comportant une structure porteuse qui renferme l'actionneur (4) ou comportant une structure porteuse qui est disposée à l'extérieur de l'actionneur (4).

3.  Actionneur rotatif selon une des revendications précédentes, comportant plusieurs structures porteuses emboîtées et/ou disposées l'une derrière l'autre le long de l'axe (z).

4.  Actionneur rotatif selon la revendication précédente, dans lequel les éléments (1.4) d'une structure porteuse et les éléments (1.5) de l'autre structure porteuse sont symétriques en miroir par rapport à un plan perpendiculaire de l'axe passant par les segments reliés (1.3).

5.  Actionneur rotatif selon une des revendications précédentes, dans lequel au moins un des segments (1.1, 1.2) est relié à un objet fixe et au moins un autre segment (1.3) est relié à un objet mobile.

6.  Actionneur rotatif selon une des revendications précédentes, dans lequel au moins un actionneur (4) est un actionneur électriquement commandable, en particulier un actionneur à semi-conducteurs ou un actionneur piézoélectrique ou un actionneur magnétostrictif ou un actionneur électromagnétique ou un actionneur électrostatique ou un actionneur en élastomère diélectrique.

7.  Actionneur rotatif selon les revendications précédentes, comportant une enceinte étanche hermétique du au moins un actionneur (4) et/ou comportant une structure porteuse hermétiquement fermée.

8.  Actionneur rotatif selon une des revendications précédentes, comportant une structure porteuse présentant une constante de ressort le long de l'axe (z) .

9.  Actionneur rotatif selon la revendication précédente, comportant une structure porteuse qui sollicite mécaniquement l'actionneur (4).

10. Actionneur rotatif selon une des revendications précédentes, dans lequel les actionneurs électriques (4) peuvent être commandés individuellement.

11. Procédé pour faire fonctionner un actionneur rotatif selon une des revendications précédentes, dans lequel, par commande électrique du au moins un actionneur (4), les segments (1.1, 1.2, 1.3) et/ou les objets reliés aux segments exécutent des mouvements de rotation les uns par rapport aux autres, qui sont proportionnels à l'amplitude de commande et/ou la polarité des signaux de commande.

12. Procédé de fonctionnement d'un actionneur rotatif selon une des revendications précédentes, dans lequel l'actionneur rotatif est actionné en boucle de commande fermée et/ou fait partie de la boucle de commande.

13. Utilisation d'un actionneur rotatif selon une des revendications précédentes pour le réglage de composants dans les systèmes d'information du conducteur, en particulier pour le réglage de composants optiques.

Fig.2

Fig.1

Fig.3

Fig.4

EP 2 759 052 B1

Fig.5

Fix: Nullwinkel der Arme α = 5 Grad, Durchmesser Drehwandler d = 10 mm

Variabel
Nullabstand der Ringbereiche:
— 2 mm
— — 4 mm
— ·— 6 mm
········ 8 mm
— ··— 10 mm
— — 15 mm
—···— 20 mm

Drehwinkel φ [Grad]

Axiale z-Längenänderung des Drehwandlers [Mikrometer]

Fig.7

Fig.6

Fig.8 a.)

Fig.8 b.)

Fig.8 c.)

Fig.9 b.)

Fig.9 a.)

Fig.11

Detail A

Fig.10

Fig.12

Fig.14

Fig.13

26

Fig.17

Fig.15

Fig.16

Fig.18. b.)

Fig.18 a.)

Fig.19 a.)

Fig.19 b.)

Fig.19 c.)

Fig.20 b.)

Fig.20 a.)

Fig.21 b.)

Fig.21 a.)

Fig.22 b.)

Fig.22 a.)

Fig.23 a.)

Fig.23 b.)

Fig.23 c.)

Fig.24 c.)

Fig.24 b.)

Fig.24 a.)

Fig.26

Fig.25 b.)

Fig.25 a.)

Fig.27

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 5626312 A